# EUROPEAN PATENT APPLICATION

(11) **EP 4 152 425 A1**
(43) Date of publication of application: **22.03.2023**
(21) Application number: 21197667.5
(22) Date of filing: 20.09.2021
(51) Int. Cl.: H01L 51/54

(54) **AN ORGANIC ELECTRONIC DEVICE COMPRISING A SUBSTRATE, AN ANODE LAYER, A CATHODE LAYER, AT LEAST ONE FIRST EMISSION LAYER, AND A HOLE INJECTION LAYER, WHEREIN THE HOLE INJECTION LAYER COMPRISES A METAL COMPLEX OF FORMULA (I) AND A COMPOUND OF FORMULA (II), WHEREIN THE HOLE INJECTION LAYER IS ARRANGED BETWEEN THE ANODE LAYER AND THE AT LEAST ONE FIRST EMISSION LAYER**

(71) Applicant: Novaled GmbH, 01099 Dresden (DE)
(72) Inventor: Uvarov, Vladimir, 01099 Dresden (DE); Willmann, Steffen, 01099 Dresden (DE); Heggemann, Ulrich, 01099 Dresden (DE)
(74) Representative: Michalski Hüttermann & Partner Patentanwälte mbB

(57) **Abstract**

The present invention relates to an organic electronic device comprising a substrate, an anode layer, a cathode layer, at least one first emission layer, and a hole injection layer, wherein the hole injection layer comprises a metal complex of formula (I) and a compound of formula (II), wherein the hole injection layer is arranged between the anode layer and the at least one first emission layer.

## Description

### Technical Field

The present invention relates to an organic electronic device, comprising a substrate, an anode layer, a cathode layer, at least one first emission layer, and a hole injection layer, wherein the hole injection layer comprises a metal complex of formula (I) and a compound of formula (II), wherein the hole injection layer is arranged between the anode layer and the at least one first emission layer.

### Background Art

Organic electronic devices, such as organic light-emitting diodes OLEDs, which are self-emitting devices, have a wide viewing angle, excellent contrast, quick response, high brightness, excellent operating voltage characteristics, and color reproduction. A typical OLED comprises an anode layer, a hole injection layer HIL, a hole transport layer HTL, an emission layer EML, an electron transport layer ETL, and a cathode layer, which are sequentially stacked on a substrate. In this regard, the HIL, the HTL, the EML, and the ETL are thin films formed from organic compounds.

When a voltage is applied to the anode and the cathode, holes injected from the anode move to the EML, via the HIL and HTL, and electrons injected from the cathode move to the EML, via the ETL. The holes and electrons recombine in the EML to generate excitons. When the excitons drop from an excited state to a ground state, light is emitted. The injection and flow of holes and electrons should be balanced, so that an OLED having the above-described structure has low operating voltage, excellent efficiency and/or a long lifetime.

Performance of an organic light emitting diode may be affected by characteristics of the organic semiconductor layers, such as the hole injection layer, and among them, may be affected by characteristics of the compounds contained in the organic semiconductor layer, such as hole transport compounds and metal complexes.

There remains a need to improve performance of organic electronic devices by providing organic semiconductor layers with improved performance, in particular to achieve improved voltage stability over time and/or higher efficiency.

### DISCLOSURE

An aspect of the present invention provides an organic electronic device comprising a substrate, an anode layer, a cathode layer, at least one first emission layer, and a hole injection layer, wherein
the hole injection layer comprises a metal complex of formula (I): 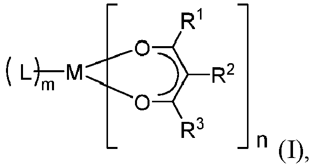 wherein
- M: is a metal;
- L: is a charge-neutral ligand, which coordinates to the metal M;
- n: is an integer selected from 1 to 4, which corresponds to the oxidation number of M;
- m: is an integer selected from 0 to 2;
- R¹: and R³ are independently selected from H, D, substituted or unsubstituted C₁ to C₁₂ alkyl, substituted or unsubstituted C₁ to C₁₂ alkoxy, substituted or unsubstituted C₆ to C₂₄ aryl, and substituted or unsubstituted C₂ to C₂₄ heteroaryl group, wherein at least one substituent is selected from halogen, F, Cl, CN, substituted or unsubstituted C₁ to C₁₂ alkyl, partially or fully fluorinated C₁ to C₁₂ alkyl, substituted or unsubstituted C₁ to C₁₂ alkoxy, partially or fully fluorinated C₁ to C₁₂ alkoxy, substituted or unsubstituted C₆ to C₁₈ aryl, and substituted or unsubstituted C₂ to C₁₈ heteroaryl, wherein the substituents of the substituted or unsubstituted C₁ to C₁₂ alkyl, substituted or unsubstituted C₁ to C₁₂ alkoxy, substituted or unsubstituted C₆ to C₁₈ aryl, and substituted or unsubstituted C₂ to C₁₈ heteroaryl are selected from halogen, F, Cl, CN, C₁ to C₆ alkyl, CF₃, OCH₃, OCF₃;
- R²: is selected from CN, C₁ to C₄ alkyl, partially or perfluorinated C₁ to C₄ alkyl, or F;

wherein at least one R¹ and/or R³ is selected from a substituted C₆ to C₂₄ aryl or substituted C₂ to C₂₄ heteroaryl group,
wherein at least one substituent of the substituted C₆ to C₂₄ aryl or substituted C₂ to C₂₄ heteroaryl group is selected from CN or partially or fully fluorinated C₁ to C₁₂ alkyl;
and a compound of formula (II) 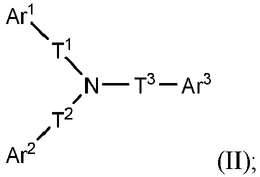
- T¹, T², T³: are independently selected from a single bond, phenylene, biphenylene, terphenylene or naphthenylene, preferably a single bond or phenylene;
- Ar¹, Ar², Ar³: are independently selected from substituted or unsubstituted C₆ to C₂₀ aryl, or substituted or unsubstituted C₃ to C₂₀ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three
substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5-to 6-member of an aromatic heterocycle, (iii) unsaturated 5- to 7-member ring of a non-heterocycle, (iv) 6-member ring of an aromatic non-heterocycle;
wherein
the substituents of Ar¹, Ar², Ar³ are selected the same or different from the group comprising H, D, F, CN, Si(R²)₃, substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted aromatic ring systems having 6 to 40 aromatic ring atoms, and substituted or unsubstituted heteroaromatic ring systems having 5 to 40 aromatic ring atoms,
unsubstituted C₆ to C₁₈ aryl, unsubstituted C₃ to C₁₈ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,
   wherein R² may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, C₆ to C₁₈ aryl or C₃ to C₁₈ heteroaryl;
wherein the hole injection layer is arranged between the anode layer and the at least one first emission layer.

It should be noted that throughout the application and the claims any Aⁿ, Bⁿ, Rⁿ, Arⁿ, Tⁿ, Xⁿ, L, M, Q etc. always refer to the same moieties, unless otherwise noted.

In the present specification, when a definition is not otherwise provided, "partially fluorinated" refers to a C₁ to C₈ alkyl group in which only part of the hydrogen atoms are replaced by fluorine atoms.

In the present specification, when a definition is not otherwise provided, "perfluorinated" refers to a C₁ to C₈ alkyl group in which all hydrogen atoms are replaced by fluorine atoms.

In the present specification, when a definition is not otherwise provided, "substituted" refers to one substituted with a deuterium, C₁ to C₁₂ alkyl and C₁ to C₁₂ alkoxy.

In the present specification, when a definition is not otherwise provided, a substituted aryl group with at least 6 C-ring atoms can be substituted with 1, 2, 3, 4 or 5 substituents. For example a substituted C₆ aryl group may have 1, 2, 3, 4 or 5 phenyl substituents.

However, in the present specification "aryl substituted" refers to a substitution with one or more aryl groups, which themselves may be substituted with one or more aryl and/or heteroaryl groups.

Correspondingly, in the present specification "heteroaryl substituted" refers to a substitution with one or more heteroaryl groups, which themselves may be substituted with one or more aryl and/or heteroaryl groups.

In the present specification, when a definition is not otherwise provided, a substituted heteroaryl group with at least 2 C-ring atoms can be substituted with one or more substituents. For example a substituted C₂ heteroaryl group may have 1 or 2 substituents.

In the present specification, when a definition is not otherwise provided, an "alkyl group" refers to a saturated aliphatic hydrocarbyl group. The alkyl group may be a C₁ to C₁₂ alkyl group. More specifically, the alkyl group may be a C₁ to C₁₀ alkyl group or a C₁ to C₆ alkyl group. For example, a C₁ to C₄ alkyl group includes 1 to 4 carbons in alkyl chain, and may be selected from methyl, ethyl, propyl, iso-propyl, n-butyl, iso-butyl, sec-butyl, and tert-butyl.

Specific examples of the alkyl group may be a methyl group, an ethyl group, a propyl group, an isopropyl group, a butyl group, an iso-butyl group, a sec-butyl group, a tert-butyl group, a pentyl group, a hexyl group.

The term "cycloalkyl" refers to saturated hydrocarbyl groups derived from a cycloalkane by formal abstraction of one hydrogen atom from a ring atom comprised in the corresponding cycloalkane. Examples of the cycloalkyl group may be a cyclopropyl group, a cyclobutyl group, a cyclopentyl group, a cyclohexyl group, a methylcyclohexyl group, an adamantly group and the like.

The term "hetero" is understood the way that at least one carbon atom, in a structure which may be formed by covalently bound carbon atoms, is replaced by another polyvalent atom. Preferably, the heteroatoms are selected from B, Si, N, P, O, S; more preferably from N, P, O, S.

The term "charge-neutral" means that the corresponding group is overall electrically neutral.

In the present specification, "aryl group" refers to a hydrocarbyl group which can be created by formal abstraction of one hydrogen atom from an aromatic ring in the corresponding aromatic hydrocarbon. Aromatic hydrocarbon refers to a hydrocarbon which contains at least one aromatic ring or aromatic ring system. Aromatic ring or aromatic ring system refers to a planar ring or ring system of covalently bound carbon atoms, wherein the planar ring or ring system comprises a conjugated system of delocalized electrons fulfilling Hückel's rule. Examples of aryl groups include monocyclic groups like phenyl or tolyl, polycyclic groups which comprise more aromatic rings linked by single bonds, like biphenyl, and polycyclic groups comprising fused rings, like naphtyl or fluoren-2-yl.

Analogously, under heteroaryl, it is especially where suitable understood a group derived by formal abstraction of one ring hydrogen from a heterocyclic aromatic ring in a compound comprising at least one such ring.

Under heterocycloalkyl, it is especially where suitable understood a group derived by formal abstraction of one ring hydrogen from a saturated cycloalkyl ring in a compound comprising at least one such ring.

The term "fused aryl rings" or "condensed aryl rings" is understood the way that two aryl rings are considered fused or condensed when they share at least two common sp²-hybridized carbon atoms.

The term "5-, 6- or 7-member ring" is understood to mean a ring comprising 5, 6 or 7 atoms. The atoms may be selected from C and one or more hetero-atoms.

In the present specification, the single bond refers to a direct bond.

In the present specification, when a definition is not otherwise provided, "substituted" refers to one substituted with a H, deuterium, C₁ to C₁₂ alkyl, unsubstituted C₆ to C₁₈ aryl, and unsubstituted C₃ to C₁₈ heteroaryl.

In the present specification, when a substituent is not named, the substituent can be a H.

In the context of the present invention, "different" means that the compounds do not have an identical chemical structure.

The term "free of', "does not contain", "does not comprise" does not exclude impurities which may be present in the compounds prior to deposition. Impurities have no technical effect with respect to the object achieved by the present invention.

As used herein, "percent by weight", "weight percent", "wt.-%", "% by weight", and variations thereof refer to a composition, component, substance or agent as the weight of that composition, component, substance or agent of the respective layer divided by the total weight of the composition thereof and multiplied by 100. It is understood that the total weight percent amount of all components, substances or agents of the respective are selected such that it does not exceed 100 wt.-%.

The term "contacting sandwiched" refers to an arrangement of three layers whereby the layer in the middle is in direct contact with the two adjacent layers.

The terms "light-absorbing layer" and "light absorption layer" are used synonymously.

The terms "light-emitting layer", "light emission layer" and "emission layer" are used synonymously.

The terms "OLED", "organic light-emitting diode" and "organic light-emitting device" are used synonymously.

The terms "anode", "anode layer" and "anode electrode" are used synonymously.

The term "at least two anode sub-layers" is understood to mean two or more anode sub-layers, for example two or three anode sub-layers.

The terms "cathode", "cathode layer" and "cathode electrode" are used synonymously.

The term "hole injection layer" is understood to mean a layer which improves charge injection from the anode layer into further layers in the organic electronic device or from further layers of the organic electronic device into the anode.

The term "hole transport layer" is understood to mean a layer which transports holes between the hole injection layer and further layers arranged between the hole injection layer and the cathode layer.

The operating voltage U is measured in Volt.

In the context of the present specification the term "essentially non-emissive" or "non-emissive" means that the contribution of the metal complex of formula (I) or the hole injection layer comprising a metal complex of formula (I), to the visible emission spectrum from an electronic device, such as OLED or display device, is less than 10 %, preferably less than 5 % relative to the visible emission spectrum. The visible emission spectrum is an emission spectrum with a wavelength of about ≥ 380 nm to about ≤ 780 nm.

In the context of the present invention, the term "sublimation " may refer to a transfer from solid state to gas phase or from liquid state to gas phase.

In the specification, hole characteristics refer to an ability to donate an electron to form a hole when an electric field is applied and that a hole formed in the anode may be easily injected into the emission layer and transported in the emission layer due to conductive characteristics according to a highest occupied molecular orbital (HOMO) level.

In addition, electron characteristics refer to an ability to accept an electron when an electric field is applied and that electrons formed in the cathode may be easily injected into the emission layer and transported in the emission layer due to conductive characteristics according to a lowest unoccupied molecular orbital (LUMO) level.

The term "HOMO level" is understood to mean the highest occupied molecular orbital and is determined in eV (electron volt).

The work function of the first metal is measured in eV (electron volt). Tabulated values of work functions can be found for example in CRC Handbook of Chemistry and Physics version 2008, p. 12-114. Further, tabulated values of work functions can be found for example at https://en.wikipedia.org/wiki/Work_function#cite_note-12.

### Advantageous Effects

Surprisingly, it was found that the organic electronic device of the present invention solves the problem underlying the present invention by enabling devices in various aspects superior over the organic electronic devices known in the art, in particular with respect to improved voltage stability over time and/or higher efficiency

According to one embodiment of the present invention, the hole injection layer does not comprise a compound of the following formulae:

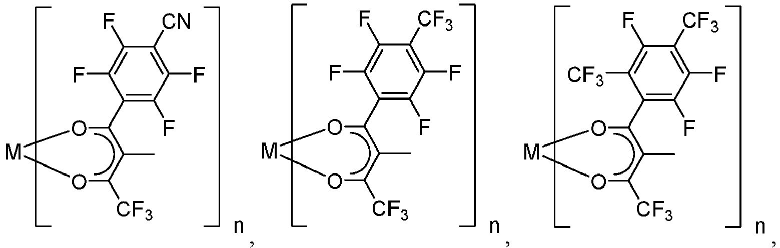

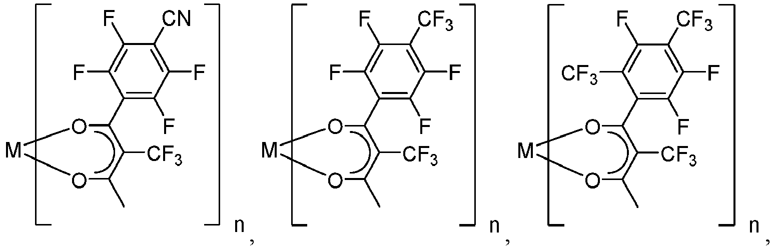

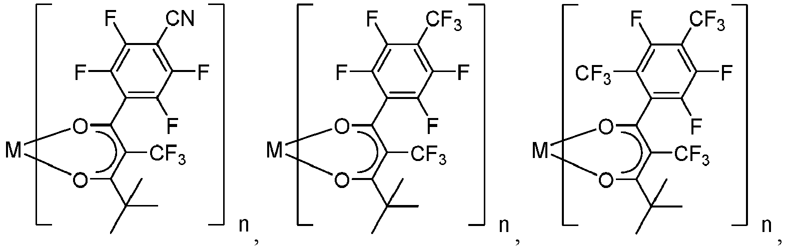

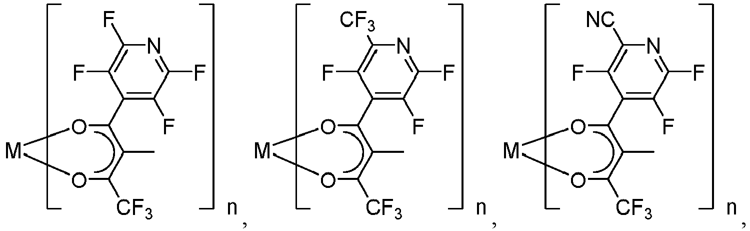

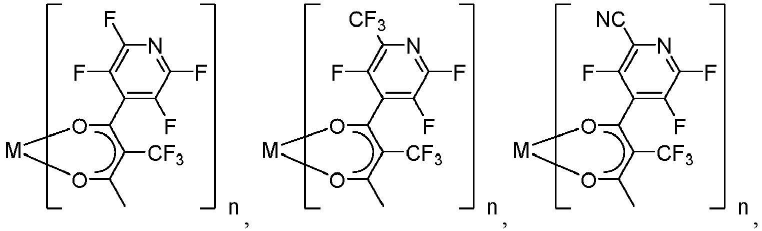

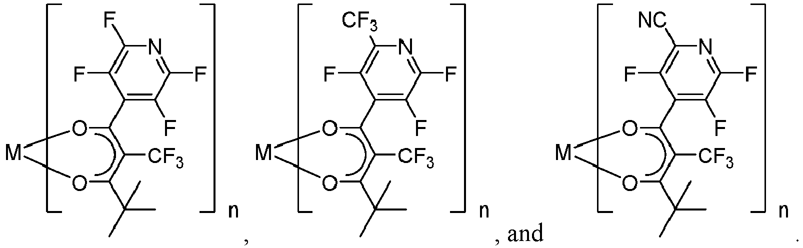

According to one embodiment of the present invention, the hole injection layer is free of of metal phthalocyanine (Pc) or CuPc, and/or the layers of the organic electronic device are free of metal phthalocyanine or CuPc. Preferably, the semiconductor layer is free of ionic liquids, metal phthalocyanine, CuPc, HAT-CN, Pyrazino[2,3-f][1,10]phenanthroline-2,3-dicarbonitrile, F₄TCNQ, metal fluoride and/or metal oxides, wherein the metal in the metal oxide is selected from Re and/or Mo.

According to one embodiment of the present invention, the charge neutral form of M has an electronegativity value according to Allen of less than 2.4.

According to one embodiment of the present invention, the metal cation M is selected from selected from alkali, alkaline earth, transition, rare earth metal or group III to V metal, preferably the metal cation M is selected from transition or group III to V metal; preferably the metal M is selected from Li(I), Na(I), K(I), Rb(I), Cs(I), Mg(II), Ca(II), Sr(II), Ba(II), Sc(III), Y(III), Ti(IV), V(III-V), Cr(III-VI), Mn(II), Mn(III), Fe(II), Fe(III), Co(II), Co(III), Ni(II), Cu(I), Cu(II), Zn(II), Pd(II), Ag(I), Au(I), Au(III), Al(III), Sc(III), Ga(III), In(III), Y(III), Eu(III), Sn(II), Sn(IV), Zr(IV), Hf(IV), Ce(IV), or Pb(II); preferably M is selected from Li(I), Na(I), K(I), Rb(I), Cs(I), Cu(II), Zn(II), Pd(II), Al(III), Sc(III), Mn(III), In(III), Y(III), Eu(III), Fe(III), Zr(IV), Hf(IV) or Ce(IV), more preferably M is Cu(II) or Fe(III), also more preferably M is Cu(II). Elements of groups IV-XI are named transition metals. According to one embodiment of the present invention, L is selected from the group comprising H₂O, C₂ to C₄₀ mono- or multi-dentate ethers and C₂ to C₄₀ thioethers, C₂ to C₄₀ amines, C₂ to C₄₀ phosphine, C₂ to C₂₀ alkyl nitrile or C₂ to C₄₀ aryl nitrile, or a compound according to Formula (III); 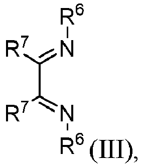 wherein R⁶ and R⁷ are independently selected from C₁ to C₂₀ alkyl, C₁ to C₂₀ heteroalkyl, C₆ to C₂₀ aryl, heteroaryl with 5 to 20 ring-forming atoms, halogenated or perhalogenated C₁ to C₂₀ alkyl, halogenated or perhalogenated C₁ to C₂₀ heteroalkyl, halogenated or perhalogenated C₆ to C₂₀ aryl, halogenated or perhalogenated heteroaryl with 5 to 20 ring-forming atoms, or at least one R⁶ and R⁷ are bridged and form a 5 to 20 member ring, or the two R⁶ and/or the two R⁷ are bridged and form a 5 to 40 member ring or form a 5 to 40 member ring comprising an unsubstituted or C₁ to C₁₂ substituted phenanthroline.

According to one embodiment of the present invention, L is selected from a group comprising:
- at least three carbon atoms, alternatively at least four carbon atoms, and/or
- at least two oxygen atoms or one oxygen and one nitrogen atom, two to four oxygen atoms, two to four oxygen atoms and zero to two nitrogen atoms, and/or
- at least one or more groups selected from halogen, F, CN, substituted or unsubstituted C₁ to C₆ alkyl, substituted or unsubstituted C₁ to C₆ alkoxy, alternatively two or more groups selected from halogen, F, CN, substituted or unsubstituted C₁ to C₆ alkyl, substituted or unsubstituted C₁ to C₆ alkoxy, at least one or more groups selected from halogen, F, CN, substituted C₁ to C₆ alkyl, substituted C₁ to C₆ alkoxy, alternatively two or more groups selected from halogen, F, CN, perfluorinated C₁ to C₆ alkyl, perfluorinated C₁ to C₆ alkoxy, one or more groups selected from substituted or unsubstituted C₁ to C₆ alkyl, substituted or unsubstituted C₆ to C₁₂ aryl, and/or substituted or unsubstituted C₃ to C₁₂ heteroaryl,

wherein the substituents are selected from D, C₆ aryl, C₃ to C₉ heteroaryl, C₁ to C₆ alkyl, C₁ to C₆ alkoxy, C₃ to C₆ branched alkyl, C₃ to C₆ cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy, COR', COOR', halogen, F or CN;
wherein R' may be selected from C₆ aryl, C₃ to C₉ heteroaryl, C₁ to C₆ alkyl, C₁ to C₆ alkoxy, C₃ to C₆ branched alkyl, C₃ to C₆ cyclic alkyl, C₃ to C₆ branched alkoxy, C₃ to C₆ cyclic alkoxy, partially or perfluorinated C₁ to C₁₆ alkyl, partially or perfluorinated C₁ to C₁₆ alkoxy, partially or perdeuterated C₁ to C₆ alkyl, partially or perdeuterated C₁ to C₆ alkoxy

According to one embodiment of the present invention, n is an integer selected from 1, 2 and 3, which corresponds to the oxidation number of M.

According to one embodiment of the present invention, m in formula (I) is an integer selected from 0 or 1, preferably 0.

The metal complex represented by formula (I) can be also named metal complex or metal acetylacetonate complex.

According to one embodiment, the metal complex of formula (I) may have a molecular weight Mw of ≥ 287 g/mol and ≤ 2000 g/mol, preferably a molecular weight Mw of ≥ 400 g/mol and ≤ 1500 g/mol, further preferred a molecular weight Mw of ≥ 580 g/mol and ≤ 1500 g/mol, in addition preferred a molecular weight Mw of ≥ 580 g/mol and ≤ 1400 g/mol, in addition preferred a molecular weight Mw of ≥ 580 g/mol and ≤ 1100 g/mol.

According to one embodiment of the present invention, R² is selected from CN, CH₃, CF₃, C₂F₅, C₃F₇ or F, preferably CN, CH₃, CF₃, C₂F₅, C₃F₇, more preferably CN, CH₃, or CF₃.

According to one embodiment of the present invention, the metal complex of formula (I) comprises at least one CF₃ group, preferably at least two CF₃ groups

According to one embodiment of the present invention, R¹ and/or R³ each are substituted by a maximum number of four substituents, preferably three, more preferably one or two.

According to one embodiment of the present invention, at least one R¹ and/or R³ is selected from a substituted C₆ to C₂₄ aryl or substituted C₂ to C₂₄ heteroaryl group,
wherein at least one substituent of the substituted C₆ to C₂₄ aryl or substituted C₂ to C₂₄ heteroaryl group is selected from CN or partially or fully fluorinated C₁ to C₁₂ alkyl; preferably partially or fully fluorinated C₁ to C₄ alkyl, more preferably CF₃.

According to one embodiment of the present invention, at least one R¹ and R³ is selected from a substituted C₆ to C₂₄ aryl or substituted C₂ to C₂₄ heteroaryl group,
wherein at least two substituents of the substituted C₆ to C₂₄ aryl or substituted C₂ to C₂₄ heteroaryl groups is selected from CN or partially or fully fluorinated C₁ to C₁₂ alkyl; preferably partially or fully fluorinated C₁ to C₄ alkyl, more preferably CF₃.

According to one embodiment of the present invention, both of R¹ and R³ are selected from a substituted C₆ to C₂₄ aryl or substituted C₂ to C₂₄ heteroaryl group,
wherein at least one substituent of the substituted C₆ to C₂₄ aryl or substituted C₂ to C₂₄ heteroaryl groups is selected from CN or partially or fully fluorinated C₁ to C₁₂ alkyl; preferably partially or fully fluorinated C₁ to C₄ alkyl, more preferably CF₃.

According to one embodiment of the present invention, both of R¹ and R³ are selected from a substituted C₆ to C₂₄ aryl or substituted C₂ to C₂₄ heteroaryl group,
wherein at least two substituents of the substituted C₆ to C₂₄ aryl or substituted C₂ to C₂₄ heteroaryl groups is selected from CN or partially or fully fluorinated C₁ to C₁₂ alkyl; preferably partially or fully fluorinated C₁ to C₄ alkyl, more preferably CF₃.

According to one embodiment of the present invention, R¹ and R³ are selected the same. According to one embodiment of the present invention, R¹ and R³ are selected differently.

According to one embodiment of the present invention, both of R¹ and R³ are selected from a substituted C₆ aryl or substituted C₂ to C₅ heteroaryl group, wherein at least one substituent of the substituted C₆ aryl or substituted C₂ to C₅ heteroaryl groups is selected from CN or partially or fully fluorinated C₁ to C₁₂ alkyl; preferably partially or fully fluorinated C₁ to C₄ alkyl, more preferably CF₃; and wherein preferably R¹ and R³ are selected the same.

According to one embodiment of the present invention, R³ is selected from a substituted C₆ to C₂₄ aryl or substituted C₂ to C₂₄ heteroaryl group, preferably substituted C₁₂ to C₂₄ aryl or substituted C₈ to C₂₄ heteroaryl,
wherein at least one substituent of the substituted C₆ to C₂₄ aryl or substituted C₂ to C₂₄ heteroaryl groups is selected from CN or partially or fully fluorinated C₁ to C₁₂ alkyl; preferably partially or fully fluorinated C₁ to C₄ alkyl, more preferably CF₃;
and R¹ is selected from substituted C₁ to C₁₂ alkyl or substituted C₁ to C₁₂ alkoxy, preferably substituted C₁ to Cᵢ₂ alkyl,
wherein at least one substituent of the C₁ to C₁₂ alkyl or substituted C₁ to C₁₂ alkoxy is selected from halogen, F, Cl, or CN.

According to one embodiment of the present invention, R³ is selected from substituted C₆ to C₂₄ aryl or substituted C₂ to C₂₄ heteroaryl group, preferably substituted C₁₂ to C₂₄ aryl or substituted C₈ to C₂₄ heteroaryl,
wherein at least one substituent of the substituted C₆ to C₂₄ aryl or substituted C₂ to C₂₄ heteroaryl groups is selected from CN or partially or fully fluorinated C₁ to C₁₂ alkyl; preferably partially or fully fluorinated C₁ to C₄ alkyl, more preferably CF₃;
and R¹ is selected from partially or fully fluorinated C₁ to C₁₂ alkyl or partially or fully fluorinated C₁ to C₁₂ alkoxy, preferably partially or fully fluorinated C₁ to C₁₂ alkyl, most preferably fully fluorinated C₁ to C₁₂ alkyl.

According to one embodiment of the present invention, at least at least one substituted or unsubstituted C₆ to C₂₄ aryl or substituted or unsubstituted C₂ to C₂₄ heteroaryl of R¹ and/or R³ is selected from the following formulae D1 to D71: 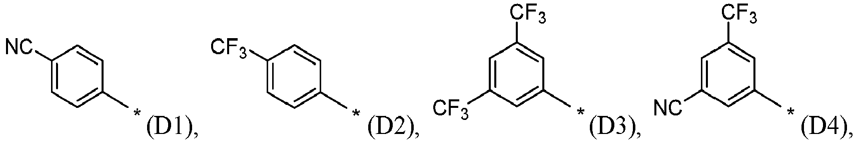 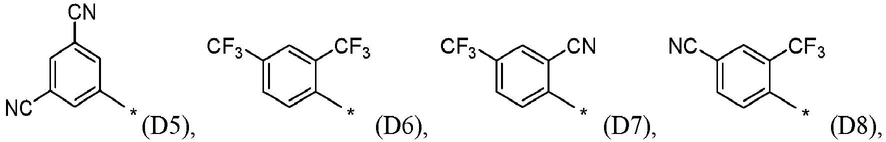 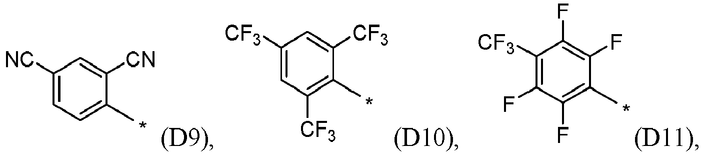 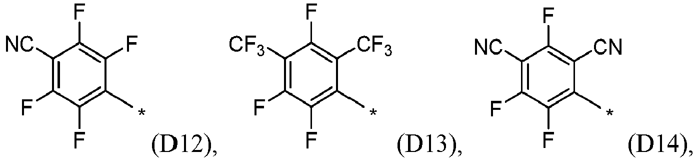 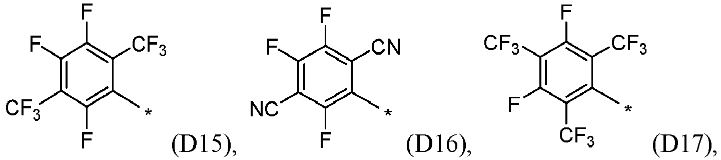 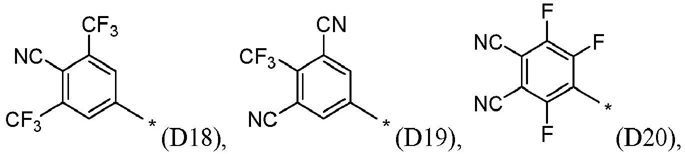 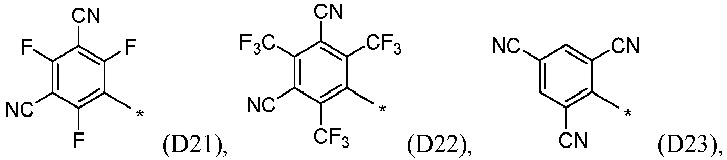 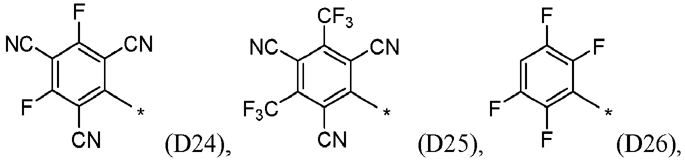 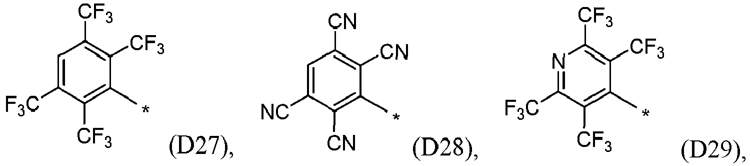 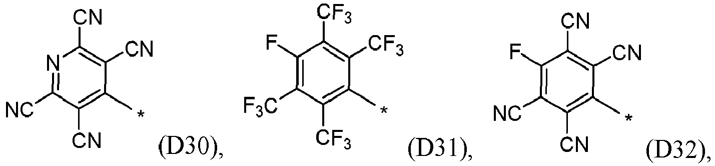 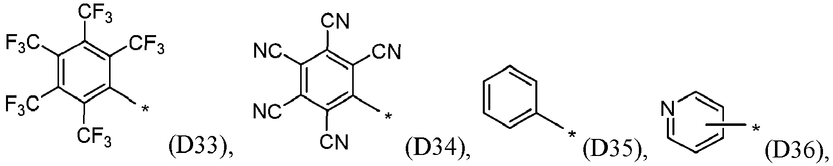 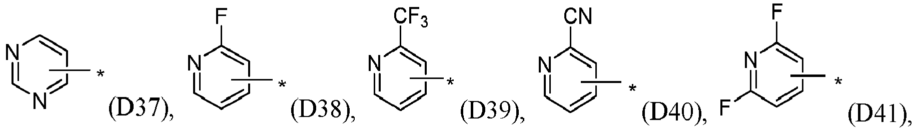 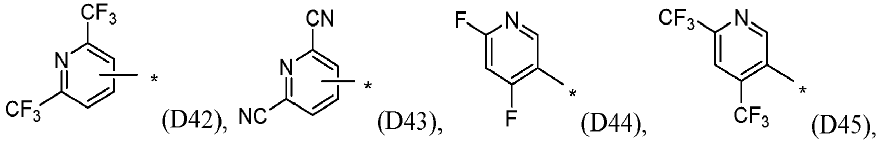 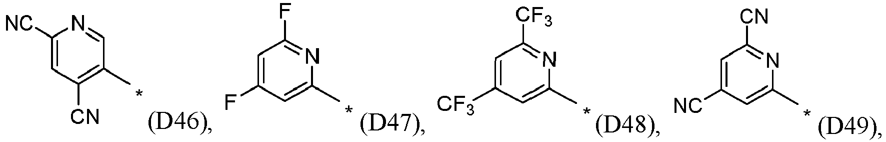 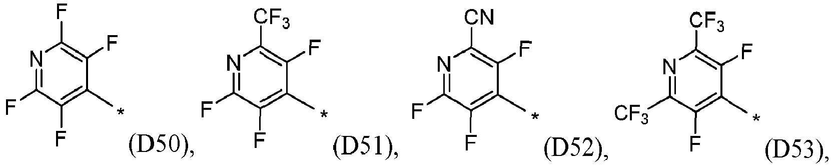 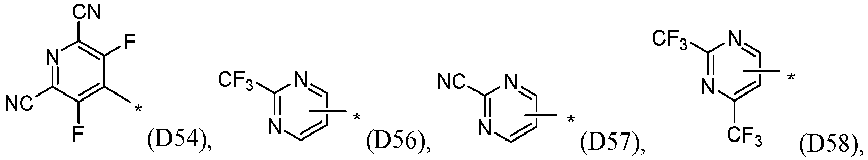 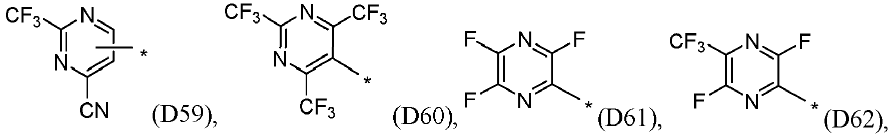 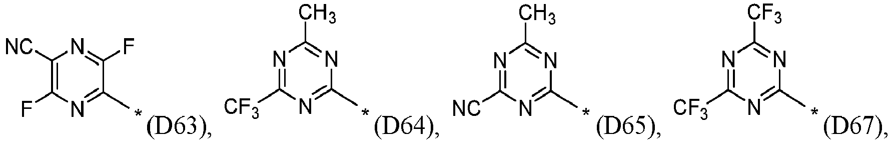 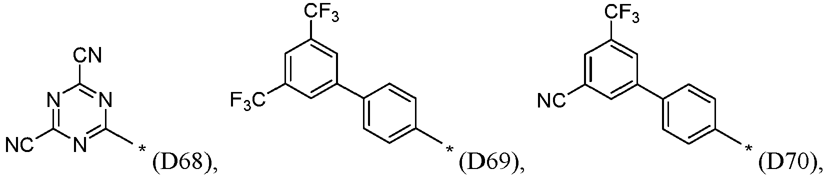 and 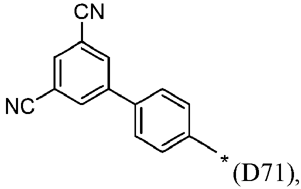 wherein the "*" denotes the binding position.

According to one embodiment of the present invention, at least one substituted or unsubstituted C₆ to C₂₄ aryl or substituted or unsubstituted C₂ to C₂₄ heteroaryl of R¹ and/or R³ is selected from the above formulae D1 to D34 and/or D38 to D71; preferably D3 to D34 and/or D39 to D71.

According to one embodiment of the present invention, R¹ is selected from formula D1 to D34 and/or D38 to D71, R² is selected from CN, C₁ to C₄ alkyl, partially or perfluorinated C₁ to C₄ alkyl, and R³ is selected from substituted or unsubstituted C₁ to C₁₂ alkyl, substituted or unsubstituted C₆ to C₂₄ aryl, and substituted or unsubstituted C₂ to C₂₄ heteroaryl group.

According to one embodiment of the present invention, the metal complex of formula (I) preferably is selected from one of the following formulae:

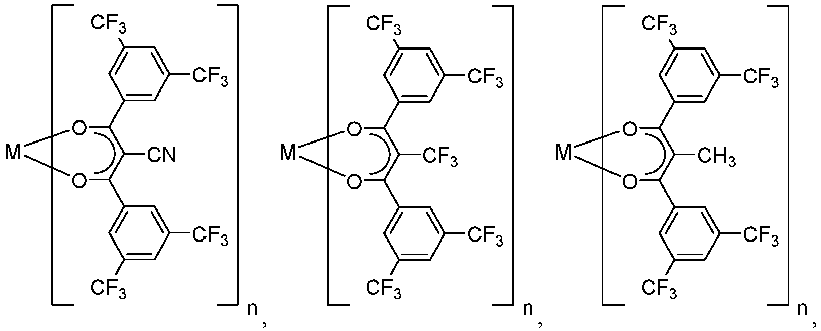

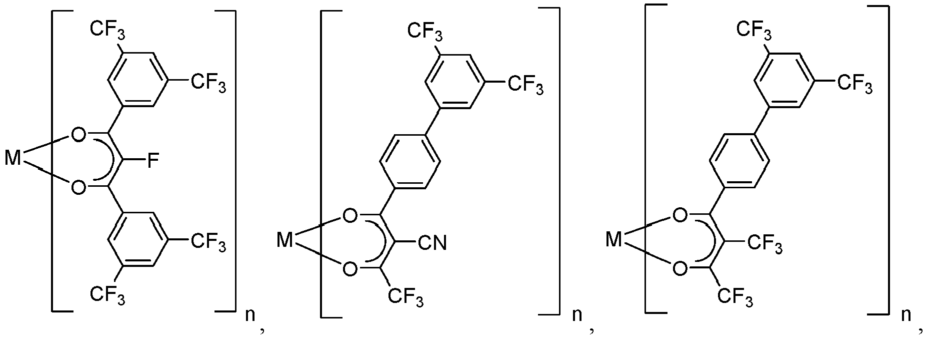

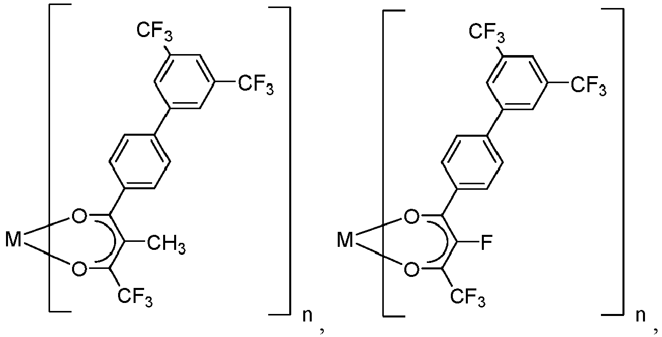

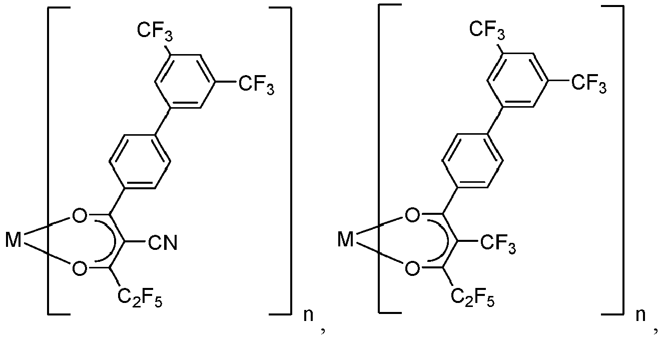

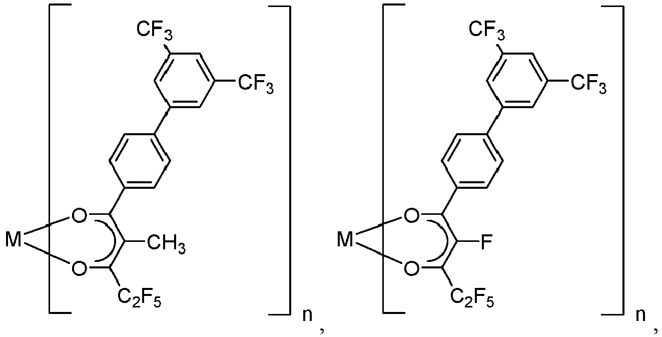

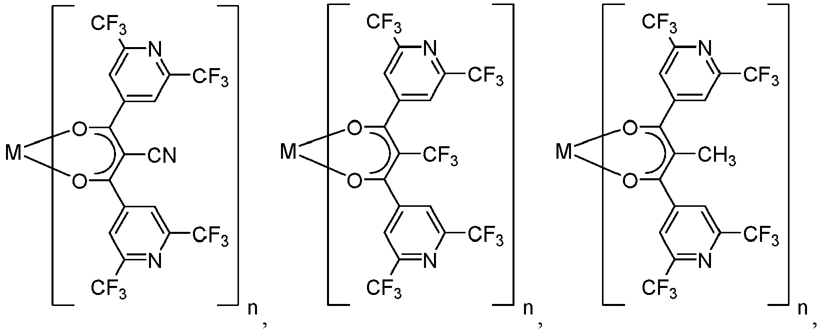

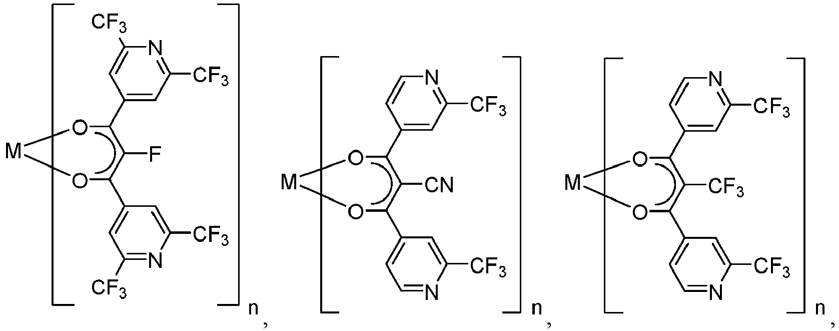

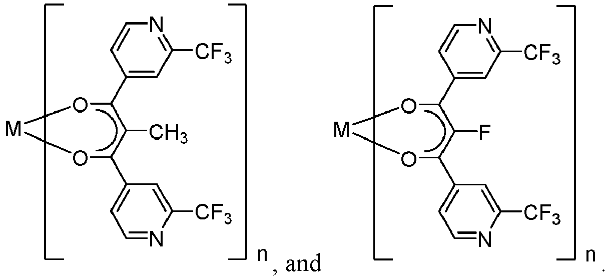

The metal complex of formula (I) and the hole injection layer comprising a metal complex of formula (I) may be essentially non-emissive or non-emissive.

The concentration of the metal complex of formula (I) may be selected from 1 to 30 wt.-%, more preferably from 5 wt.-% to 25 wt.-%, based on the weight of the hole injection layer.

The concentration of the metal complex of formula (I) may be selected from 1 to 30 vol.-%, more preferably from 5 vol.-% to 25 vol.-%, based on the volume of the hole injection layer.

### Compound of formula (II)

According to one embodiment of the present invention, the compound of formula (II) is a matrix compound, preferably a substantially covalent matrix compound.

According to one embodiment, the substantially covalent matrix compound may have a molecular weight Mw of ≥ 400 and ≤ 2000 g/mol, preferably a molecular weight Mw of ≥ 450 and ≤ 1500 g/mol, further preferred a molecular weight Mw of ≥ 500 and ≤ 1000 g/mol, in addition preferred a molecular weight Mw of ≥ 550 and ≤ 900 g/mol, also preferred a molecular weight Mw of ≥ 600 and ≤ 800 g/mol.

According to an embodiment wherein T¹, T², and T³ may be independently selected from a single bond, phenylene, biphenylene or terphenylene. According to an embodiment wherein T¹, T², and T³ may be independently selected from phenylene, biphenylene or terphenylene and one of T¹, T², and T³ are a single bond. According to an embodiment wherein T¹, T², and T³ may be independently selected from phenylene or biphenylene and one of T¹, T², and T³ are a single bond. According to an embodiment wherein T¹, T², and T³ may be independently selected from phenylene or biphenylene and two of T¹, T², and T³ are a single bond.

According to an embodiment wherein T¹, T² and T³ may be independently selected from phenylene and one of T¹, T² and T³ are a single bond. According to an embodiment wherein T¹, T² and T³ may be independently selected from phenylene and two of T¹, T² and T³ are a single bond.

According to one embodiment of the present invention Ar¹, Ar², and Ar³ are independently selected from E1 to E16: 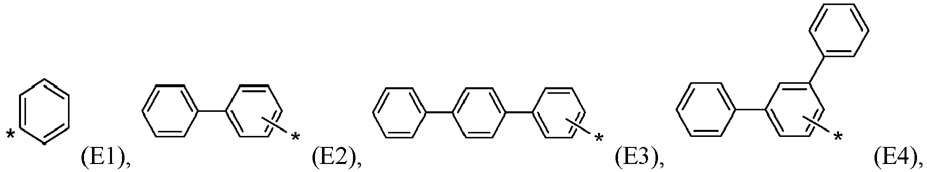 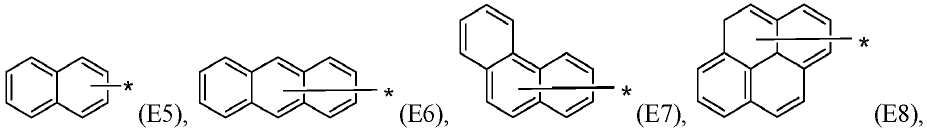 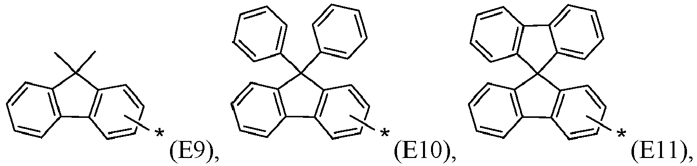 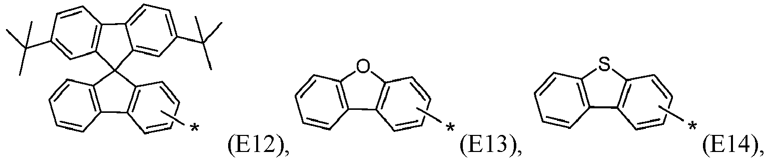 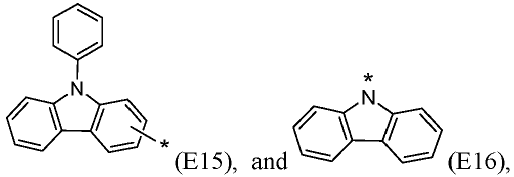 wherein the asterisk "*" denotes the binding position.

According to an embodiment, Ar¹, Ar², and Ar³ may be independently selected from E1 to E15; alternatively selected from E1 to E10 and E13 to E15.

According to an embodiment, wherein Ar¹, Ar², Ar³, Ar⁴ and Ar⁵ may be independently selected from the group consisting of E1, E2, E5, E7, E9, E10, E13 to E16.

The rate onset temperature may be in a range particularly suited to mass production, when Ar¹, Ar², and Ar³ are selected in this range.

The compound according to formula (II) may be also referred to as "hole transport compound".

According to one embodiment, the compound according to formula (II) comprises at least one naphthyl group, carbazole group, dibenzofuran group, dibenzothiophene group and/or substituted fluorenyl group, wherein the substituents are independently selected from methyl, phenyl or fluorenyl.

According to one embodiment of the invention, the compound of formula (II) has a HOMO level smaller than the HOMO level of N2,N2,N2',N2',N7,N7,N7',N7'-octakis(4-methoxyphenyl)-9,9'-spirobi[fluorene]-2,2',7,7'-tetraamine, preferably smaller than N4,N4,N4',N4'-tetrakis(4-methoxyphenyl)biphenyl-4,4'-diamine, more preferred smaller than N4,N4'-bis(9,9-dimethyl-9H-fluoren-2-yl)-N4,N4'-diphenyl-[1,1'-biphenyl]-4,4'-diamine, when determined by the same method. The HOMO level of N2,N2,N2',N2',N7,N7,N7',N7'-octakis(4-methoxyphenyl)-9,9'-spirobi[fluorene]-2,2',7,7'-tetraamine is -4.27 eV, the HOMO level of N4,N4,N4',N4'-tetrakis(4-methoxyphenyl)biphenyl-4,4'-diamine is -4.34 eV, and the HOMO level of N4,N4'-bis(9,9-dimethyl-9H-fluoren-2-yl)-N4,N4'-diphenyl-[1,1'-biphenyl]-4,4'-diamine is -4.64 eV, when calculated using TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

According to one embodiment of the invention, the compound of formula (II) has a HOMO level smaller than -4.27 eV, preferably smaller than -4.34 eV, even more preferred smaller than -4.34 eV, also preferred smaller than -4.65 eV when calculated using TURBOMOLE V6.5 (TURBOMOLE GmbH, Litzenhardtstrasse 19, 76135 Karlsruhe, Germany) by applying the hybrid functional B3LYP with a 6-31G* basis set in the gas phase.

The term "having a HOMO level smaller than" in the context of the present invention means that the absolute value of the HOMO level is greater than the absolute value of the HOMO level to which it is compared to. Particularly, the term "having a HOMO level smaller than" in the context of the present invention means that the HOMO level is further away from vacuum level than the value of the HOMO level to which it is compared to.

According to an embodiment of the electronic device, the compound of formula (II) is selected from one of the following formulae K1 to K16:

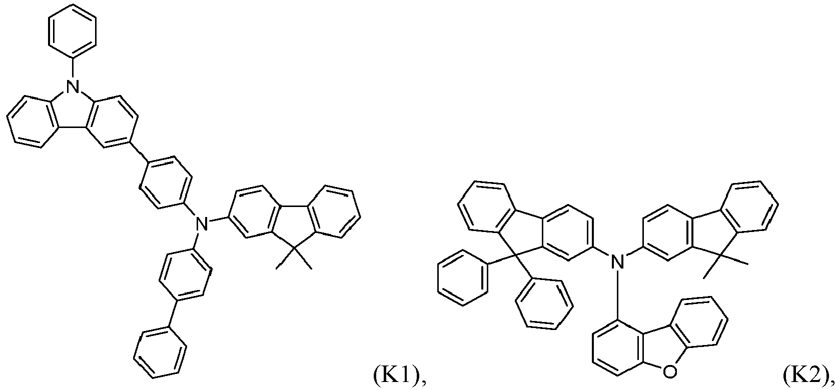

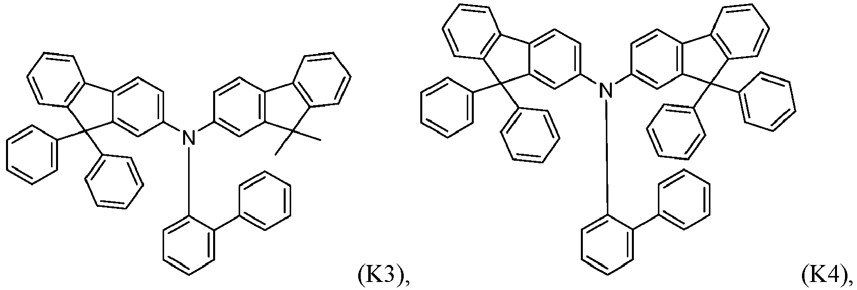

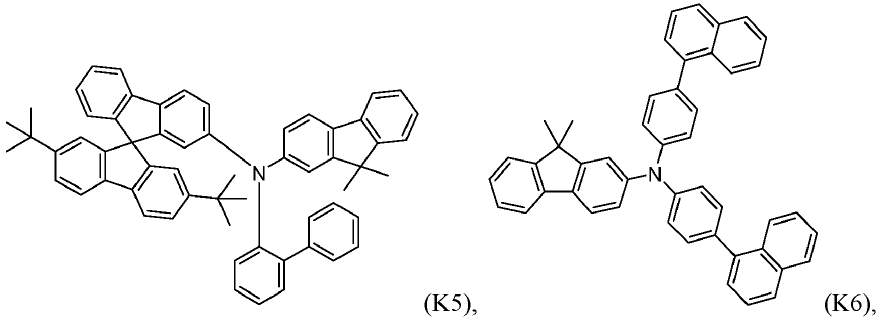

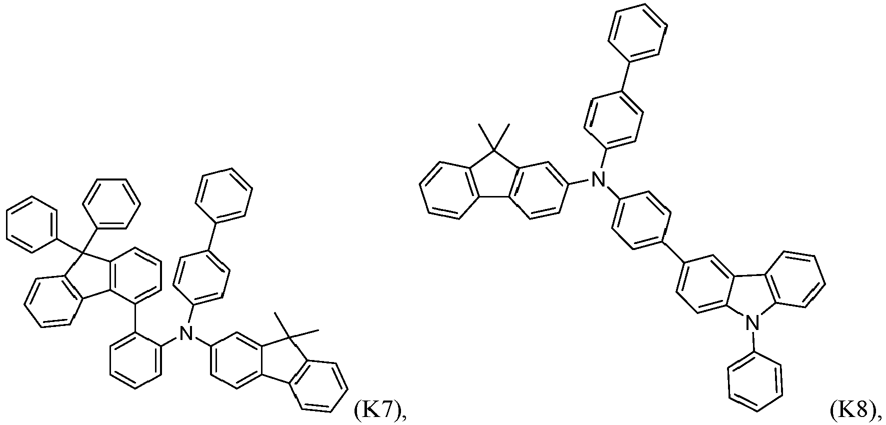

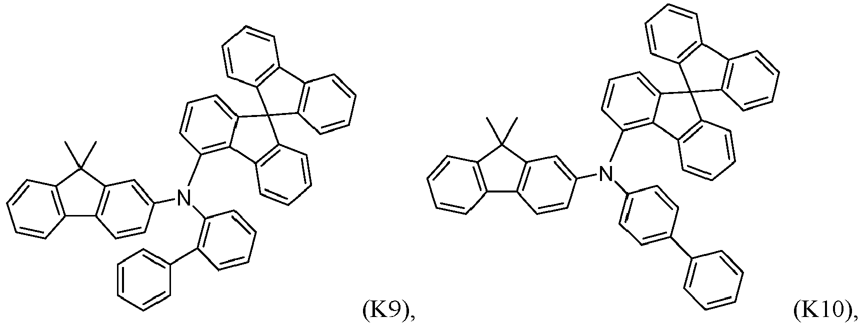

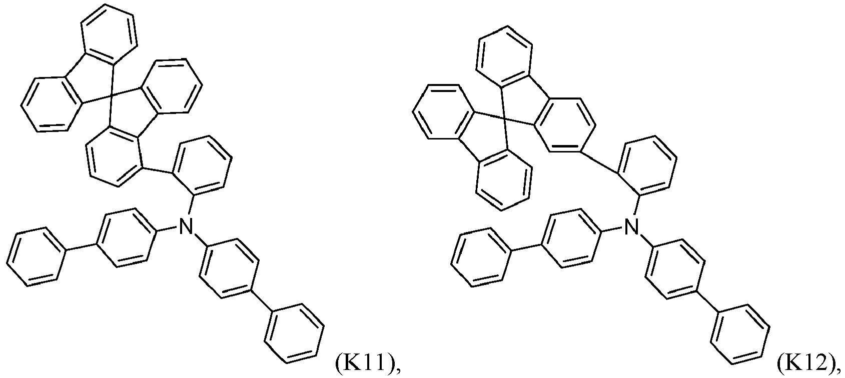

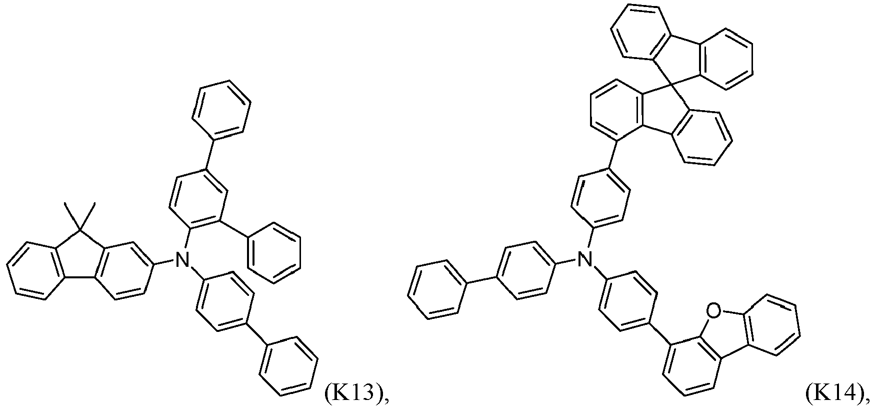

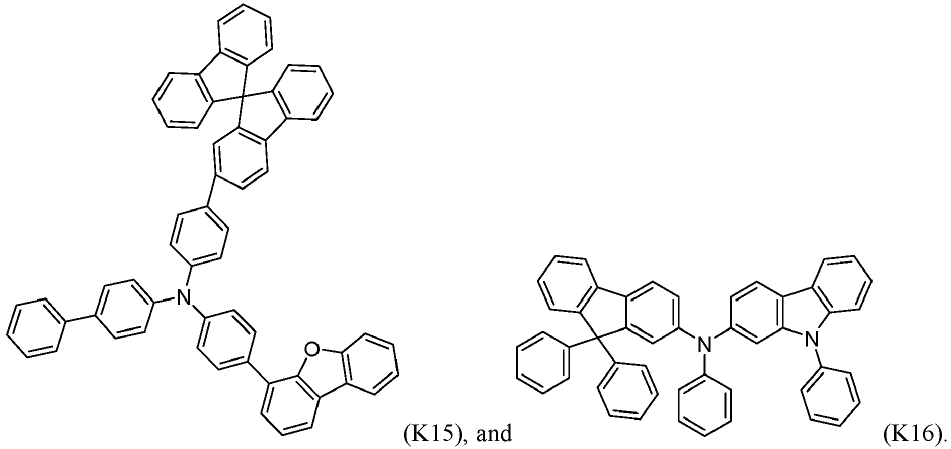

The substantially covalent matrix compound may be free of HTM014, HTM081, HTM163, HTM222, EL-301, HTM226, HTM355, HTM133, HTM334, HTM604 and EL-22T. The abbreviations denote the manufacturers' names, for example, of Merck or Lumtec.

According to one embodiment of the invention, the thickness of the hole injection layer is in the range of 1 nm to 20 nm, preferably in the range of 1 nm to 15 nm, more preferably in the range of 2 nm to 10 nm.

According to one embodiment of the present invention, the hole injection layer is in direct contact to the anode layer.

### Further layers

In accordance with the invention, the organic electronic device may comprise, besides the layers already mentioned above, further layers. Exemplary embodiments of respective layers are described in the following:

### Substrate

The substrate may be any substrate that is commonly used in manufacturing of, electronic devices, such as organic light-emitting diodes. If light is to be emitted through the substrate, the substrate shall be a transparent or semitransparent material, for example a glass substrate or a transparent plastic substrate. If light is to be emitted through the top surface, the substrate may be both a transparent as well as a non-transparent material, for example a glass substrate, a plastic substrate, a metal substrate, a silicon substrate or a backplane.

### Anode layer

The anode layer may be formed by depositing or sputtering a material that is used to form the anode layer. The material used to form the anode layer may be a high work-function material, so as to facilitate hole injection. The anode material may also be selected from a low work function material (i.e. aluminum). The anode electrode may be a transparent or reflective electrode. Transparent conductive oxides, such as indium tin oxide (ITO), indium zinc oxide (IZO), tin-dioxide (SnO2), aluminum zinc oxide (AlZO) and zinc oxide (ZnO), may be used to form the anode electrode. The anode layer may also be formed using metals, typically silver (Ag), gold (Au), or metal alloys.

According to one embodiment of the present invention, the anode layer comprises a first anode sub-layer and a second anode sub-layer, wherein
- the first anode sub-layer comprises a first metal having a work function in the range of ≥ 4 and ≤ 6 eV, and
- the second anode sub-layer comprises a transparent conductive oxide; and
- the second anode sub-layer is arranged closer to the hole injection layer.

According to one embodiment of the present invention, the first metal of the first anode sub-layer may be selected from the group comprising Ag, Mg, Al, Cr, Pt, Au, Pd, Ni, Nd, Ir, preferably Ag, Au or Al, and more preferred Ag.

According to one embodiment of the present invention, the first anode sub-layer has have a thickness in the range of 5 to 200 nm, alternatively 8 to 180 nm, alternatively 8 to 150 nm, alternatively 100 to 150 nm.

According to one embodiment of the present invention, the first anode sub-layer is formed by depositing the first metal via vacuum thermal evaporation.

It is to be understood that the first anode layer is not part of the substrate.

According to one embodiment of the present invention, the transparent conductive oxide of the second anode sub layer is selected from the group selected from the group comprising indium tin oxide or indium zinc oxide, more preferred indium tin oxide.

According to one embodiment of the present invention, the second anode sub-layer may has a thickness in the range of 3 to 200 nm, alternatively 3 to 180 nm, alternatively 3 to 150 nm, alternatively 3 to 20 nm.

According to one embodiment of the present invention, the second anode sub-layer may be formed by sputtering of the transparent conductive oxide.

According to one embodiment of the present invention, anode layer of the organic electronic device comprises in addition a third anode sub-layer comprising a transparent conductive oxide, wherein the third anode sub-layer is arranged between the substrate and the first anode sub-layer.

According to one embodiment of the present invention, the third anode sub-layer comprises a transparent oxide, preferably from the group selected from the group comprising indium tin oxide or indium zinc oxide, more preferred indium tin oxide.

According to one embodiment of the present invention, the third anode sub-layer may has a thickness in the range of 3 to 200 nm, alternatively 3 to 180 nm, alternatively 3 to 150 nm, alternatively 3 to 20 nm.

According to one embodiment of the present invention, the third anode sub-layer may be formed by sputtering of the transparent conductive oxide.

It is to be understood that the third anode layer is not part of the substrate.

According to one embodiment of the present invention, the anode layer comprises a first anode sub-layer comprising of Ag, a second anode sub-layer comprising of transparent conductive oxide, preferably ITO, and a third anode sub-layer comprising of transparent conductive oxide, preferably ITO; wherein the first anode sub-layer is arranged between the second and the third anode sub-layer.

### Hole transport layer

According to one embodiment of the present invention, the organic electronic device comprises a hole transport layer, wherein the hole transport layer is arranged between the hole injection layer and the at least one first emission layer.

The hole transport layer (HTL) may be formed on the HIL by vacuum deposition, spin coating, slot-die coating, printing, casting, Langmuir-Blodgett (LB) deposition, or the like. When the HTL is formed by vacuum deposition or spin coating, the conditions for deposition and coating may be similar to those for the formation of the HIL. However, the conditions for the vacuum or solution deposition may vary, according to the compound that is used to form the HTL.

The HTL may be formed of any compound that is commonly used to form a HTL. Compounds that can be suitably used are disclosed for example in Yasuhiko Shirota and Hiroshi Kageyama, Chem. Rev. 2007, 107, 953-1010 and incorporated by reference. Examples of the compound that may be used to form the HTL are: carbazole derivatives, such as N-phenylcarbazole or polyvinylcarbazole; benzidine derivatives, such as N,N'-bis(3-methylphenyl)-N,N'-diphenyl-[1,1-biphenyl]-4,4'-diamine (TPD), or N,N'-di(naphthalen-1-yl)-N,N'-diphenyl benzidine (alpha-NPD); and triphenylamine-based compound, such as 4,4',4"-tris(N-carbazolyl)triphenylamine (TCTA). Among these compounds, TCTA can transport holes and inhibit excitons from being diffused into the EML.

According to one embodiment of the present invention, the hole transport layer may comprise a substantially covalent matrix compound as described above.

According to one embodiment of the present invention, the hole transport layer may comprise a compound of formula (II) as described above.

According to one embodiment of the present invention, the hole injection layer and the hole transport layer comprises the same substantially covalent matrix compound as described above.

According to one embodiment of the present invention, the hole injection layer and the hole transport layer comprises the same compound of formula (II) as described above.

The thickness of the HTL may be in the range of about 5 nm to about 250 nm, preferably, about 10 nm to about 200 nm, further about 20 nm to about 190 nm, further about 40 nm to about 180 nm, further about 60 nm to about 170 nm, further about 80 nm to about 160 nm, further about 100 nm to about 160 nm, further about 120 nm to about 140 nm. A preferred thickness of the HTL may be 170 nm to 200 nm.

When the thickness of the HTL is within this range, the HTL may have excellent hole transporting characteristics, without a substantial penalty in driving voltage.

According to one embodiment of the present invention, the organic electronic device further comprises a hole transport layer, wherein the hole transport layer is arranged between the hole injection layer and the at least one emission layer.

According to one embodiment of the present invention, the hole transport layer comprises a matrix compound, wherein the matrix compound preferably is a compound according to formula (II), wherein more preferably the compound according to formula (II) in the hole injection layer and hole transport layer are selected the same.

### Electron blocking layer

The function of an electron blocking layer (EBL) is to prevent electrons from being transferred from an emission layer to the hole transport layer and thereby confine electrons to the emission layer. Thereby, efficiency, operating voltage and/or lifetime are improved. Typically, the electron blocking layer comprises a triarylamine compound. The triarylamine compound may have a LUMO level closer to vacuum level than the LUMO level of the hole transport layer. The electron blocking layer may have a HOMO level that is further away from vacuum level compared to the HOMO level of the hole transport layer. The thickness of the electron blocking layer may be selected between 2 and 20 nm.

If the electron blocking layer has a high triplet level, it may also be described as triplet control layer.

The function of the triplet control layer is to reduce quenching of triplets if a phosphorescent green or blue emission layer is used. Thereby, higher efficiency of light emission from a phosphorescent emission layer can be achieved. The triplet control layer is selected from triarylamine compounds with a triplet level above the triplet level of the phosphorescent emitter in the adjacent emission layer. Suitable compounds for the triplet control layer, in particular the triarylamine compounds, are described in EP 2 722 908 A1.

### Emission layer (EML)

The EML may be formed on the HTL by vacuum deposition, spin coating, slot-die coating, printing, casting, LB deposition, or the like. When the EML is formed using vacuum deposition or spin coating, the conditions for deposition and coating may be similar to those for the formation of the HIL. However, the conditions for deposition and coating may vary, according to the compound that is used to form the EML.

According to one embodiment of the present invention, the emission layer does not comprise the metal complex of formula (I).

The emission layer (EML) may be formed of a combination of a host and an emitter dopant. Example of the host are Alq3, 4,4'-N,N'-dicarbazole-biphenyl (CBP), poly(n-vinylcarbazole) (PVK), 9,10-di(naphthalene-2-yl)anthracene (ADN), 4,4',4"-tris(carbazol-9-yl)-triphenylamine(TCTA), 1,3,5-tris(N-phenylbenzimidazole-2-yl)benzene (TPBI), 3-tert-butyl-9,10-di-2-naphthylanthracenee (TBADN), distyrylarylene (DSA) and bis(2-(2-hydroxyphenyl)benzo-thiazolate)zinc (Zn(BTZ)2).

The emitter dopant may be a phosphorescent or fluorescent emitter. Phosphorescent emitters and emitters which emit light via a thermally activated delayed fluorescence (TADF) mechanism may be preferred due to their higher efficiency. The emitter may be a small molecule or a polymer.

Examples of red emitter dopants are PtOEP, Ir(piq)3, and Btp2lr(acac), but are not limited thereto. These compounds are phosphorescent emitters, however, fluorescent red emitter dopants could also be used.

Examples of phosphorescent green emitter dopants are Ir(ppy)3 (ppy = phenylpyridine), Ir(ppy)2(acac), Ir(mpyp)3.

Examples of phosphorescent blue emitter dopants are F2Irpic, (F2ppy)2Ir(tmd) and Ir(dfppz)3 and ter-fluorene. 4.4'-bis(4-diphenyl amiostyryl)biphenyl (DPAVBi), 2,5,8,11-tetra-tert-butyl perylene (TBPe) are examples of fluorescent blue emitter dopants.

The amount of the emitter dopant may be in the range from about 0.01 to about 50 parts by weight, based on 100 parts by weight of the host. Alternatively, the emission layer may consist of a light-emitting polymer. The EML may have a thickness of about 10 nm to about 100 nm, for example, from about 20 nm to about 60 nm. When the thickness of the EML is within this range, the EML may have excellent light emission, without a substantial penalty in driving voltage.

### Hole blocking layer (HBL)

A hole blocking layer (HBL) may be formed on the EML, by using vacuum deposition, spin coating, slot-die coating, printing, casting, LB deposition, or the like, in order to prevent the diffusion of holes into the ETL. When the EML comprises a phosphorescent dopant, the HBL may have also a triplet exciton blocking function.

The HBL may also be named auxiliary ETL or a-ETL.

When the HBL is formed using vacuum deposition or spin coating, the conditions for deposition and coating may be similar to those for the formation of the HIL. However, the conditions for deposition and coating may vary, according to the compound that is used to form the HBL. Any compound that is commonly used to form a HBL may be used. Examples of compounds for forming the HBL include oxadiazole derivatives, triazole derivatives, phenanthroline derivatives and azine derivatives, preferably triazine or pyrimidine derivatives.

The HBL may have a thickness in the range from about 5 nm to about 100 nm, for example, from about 10 nm to about 30 nm. When the thickness of the HBL is within this range, the HBL may have excellent hole-blocking properties, without a substantial penalty in driving voltage.

### Electron transport layer (ETL)

The organic electronic device according to the present invention may further comprise an electron transport layer (ETL).

According to another embodiment of the present invention, the electron transport layer may further comprise an azine compound, preferably a triazine compound.

In one embodiment, the electron transport layer may further comprise a dopant selected from an alkali organic complex, preferably LiQ.

The thickness of the ETL may be in the range from about 15 nm to about 50 nm, for example, in the range from about 20 nm to about 40 nm. When the thickness of the EIL is within this range, the ETL may have satisfactory electron-injecting properties, without a substantial penalty in driving voltage.

According to another embodiment of the present invention, the organic electronic device may further comprise a hole blocking layer and an electron transport layer, wherein the hole blocking layer and the electron transport layer comprise an azine compound. Preferably, the azine compound is a triazine compound.

### Electron injection layer (EIL)

An optional EIL, which may facilitates injection of electrons from the cathode, may be formed on the ETL, preferably directly on the electron transport layer. Examples of materials for forming the EIL include lithium 8-hydroxyquinolinolate (LiQ), LiF, NaCl, CsF, Li2O, BaO, Ca, Ba, Yb, Mg which are known in the art. Deposition and coating conditions for forming the EIL are similar to those for formation of the HIL, although the deposition and coating conditions may vary, according to the material that is used to form the EIL.

The thickness of the EIL may be in the range from about 0.1 nm to about 10 nm, for example, in the range from about 0.5 nm to about 9 nm. When the thickness of the EIL is within this range, the EIL may have satisfactory electron-injecting properties, without a substantial penalty in driving voltage.

### Cathode layer

The cathode layer is formed on the ETL or optional EIL. The cathode layer may be formed of a metal, an alloy, an electrically conductive compound, or a mixture thereof. The cathode electrode may have a low work function. For example, the cathode layer may be formed of lithium (Li), magnesium (Mg), aluminum (Al), aluminum (Al)-lithium (Li), calcium (Ca), barium (Ba), ytterbium (Yb), magnesium (Mg)-indium (In), magnesium (Mg)-silver (Ag), or the like. Alternatively, the cathode electrode may be formed of a transparent conductive oxide, such as ITO or IZO.

The thickness of the cathode layer may be in the range from about 5 nm to about 1000 nm, for example, in the range from about 10 nm to about 100 nm. When the thickness of the cathode layer is in the range from about 5 nm to about 50 nm, the cathode layer may be transparent or semitransparent even if formed from a metal or metal alloy.

According to a preferred embodiment of the present invention, the cathode is transparent.

It is to be understood that the cathode layer is not part of an electron injection layer or the electron transport layer.

### Organic light-emitting diode (OLED)

The organic electronic device according to the invention may be an organic light-emitting device.

According to one aspect of the present invention, there is provided an organic light-emitting diode (OLED) comprising: a substrate; an anode electrode formed on the substrate; a hole injection layer comprising a metal complex of formula (I), a hole transport layer, an emission layer, an electron transport layer and a cathode electrode.

According to another aspect of the present invention, there is provided an OLED comprising: a substrate; an anode electrode formed on the substrate; a hole injection layer comprising a metal complex of formula (I), a hole transport layer, an electron blocking layer, an emission layer, a hole blocking layer, an electron transport layer and a cathode electrode.

According to another aspect of the present invention, there is provided an OLED comprising: a substrate; an anode electrode formed on the substrate; a hole injection layer comprising a metal complex of formula (I), a hole transport layer, an electron blocking layer, an emission layer, a hole blocking layer, an electron transport layer, an electron injection layer, and a cathode electrode.

According to various embodiments of the present invention, there may be provided OLEDs layers arranged between the above mentioned layers, on the substrate or on the top electrode.

### Organic electronic device

According to one embodiment of the present invention, the organic electronic device is a light emitting device or a display device. More preferably, the electronic device is a display device.

The present invention furthermore relates to a display device comprising an organic electronic device according to the present invention.

According to another aspect of the present invention, there is provided a method of manufacturing an organic electronic device, the method using:
- at least one deposition source, preferably two deposition sources and more preferred at least three deposition sources.

The methods for deposition that can be suitable comprise:
- deposition via vacuum thermal evaporation;
- deposition via solution processing, preferably the processing is selected from spin-coating, printing, casting; and/or
- slot-die coating.

According to various embodiments of the present invention, the method may further include forming on the anode electrode, at least one layer selected from the group consisting of forming a hole transport layer or forming a hole blocking layer, and an emission layer between the anode electrode and the first electron transport layer.

According to various embodiments of the present invention, the method may further include the steps for forming an organic light-emitting diode (OLED), wherein
- on a substrate an anode electrode is formed,
- on the anode electrode a hole injection layer comprising a metal complex of formula (I) is formed,
- on the hole injection layer comprising a metal complex of formula (I) a hole transport layer is formed,
- on the hole transport layer an emission layer is formed,
- on the emission layer an electron transport layer is formed, optionally a hole blocking layer is formed on the emission layer,
- and finally a cathode electrode is formed,
- optional a hole blocking layer is formed in that order between the first anode electrode and the emission layer,
- optional an electron injection layer is formed between the electron transport layer and the cathode electrode.

According to various embodiments, the OLED may have the following layer structure, wherein the layers having the following order:
anode, hole injection layer comprising a metal complex of formula (I) according to the invention, first hole transport layer, second hole transport layer, emission layer, optional hole blocking layer, electron transport layer, optional electron injection layer, and cathode.

According to another aspect of the invention, it is provided an electronic device comprising at least one organic light emitting device according to any embodiment described throughout this application, preferably, the electronic device comprises the organic light emitting diode in one of embodiments described throughout this application.

### Ink formulation

According to another aspect of the present invention an ink formulation is provided, wherein the ink formulation comprises at least one metal complex of formula (I) and a compound of formula (II).

According to one embodiment the ink formulation comprises a solvent. The solvent of the ink formulation may be selected from anisole and/or benzonitrile, preferably it is a mixture of anisole and benzonitrile.

According to one embodiment the mixture of anisole and benzonitrile is of 5 : 1 to 1 : 5, 4 : 1 to 1 : 4, 3 : 1 to 1 : 3, 2 : 1 to 1 : 2 or 1:1; preferred is a mixture of anisole and benzonitrile of 5:1.

Hereinafter, the embodiments are illustrated in more detail with reference to examples. However, the present disclosure is not limited to the following examples. Reference will now be made in detail to the exemplary aspects.

### Description of the Drawings

The aforementioned components, as well as the claimed components and the components to be used in accordance with the invention in the described embodiments, are not subject to any special exceptions with respect to their size, shape, material selection and technical concept such that the selection criteria known in the pertinent field can be applied without limitations.

Additional details, characteristics and advantages of the object are disclosed in the dependent claims and the following description of the respective figures which in an exemplary fashion show preferred embodiments according to the invention. Any embodiment does not necessarily represent the full scope, however, and reference is made therefore to the claims and herein for interpreting the scope. It is to be understood that both the foregoing general description and the following detailed description are exemplary and explanatory only and are intended to provide further explanation of the present invention as claimed.

### Figures 1 to 8

FIG. 1 is a schematic sectional view of an organic electronic device, according to an exemplary embodiment of the present invention;
FIG. 2 is a schematic sectional view of an organic electronic device, according to an exemplary embodiment of the present invention;
FIG. 3 is a schematic sectional view of an organic electronic device, according to an exemplary embodiment of the present invention.
FIG. 4 is a schematic sectional view of an organic electronic device, according to an exemplary embodiment of the present invention;
FIG. 5 is a schematic sectional view of an organic electronic device, according to an exemplary embodiment of the present invention;
FIG. 6 is a schematic sectional view of an organic electronic device, according to an exemplary embodiment of the present invention;
FIG. 7 is a schematic sectional view of an organic electronic device, according to an exemplary embodiment of the present invention;
FIG. 8 is a schematic sectional view of an organic electronic device, according to an exemplary embodiment of the present invention;

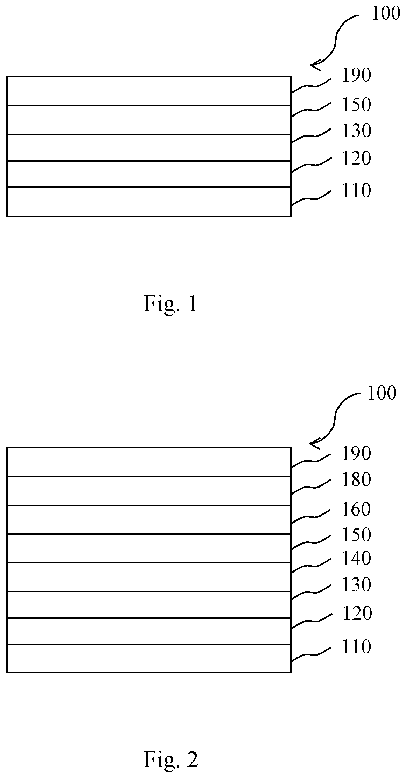

Hereinafter, the figures 1 to 9 are illustrated in more detail with reference to examples. However, the present disclosure is not limited to the following figures.

Herein, when a first element is referred to as being formed or disposed "on" or "onto" a second element, the first element can be disposed directly on the second element, or one or more other elements may be disposed there between. When a first element is referred to as being formed or disposed "directly on" or "directly onto" a second element, no other elements are disposed there between.

FIG. 1 is a schematic sectional view of an organic electronic device 100, according to an exemplary embodiment of the present invention. The organic electronic device 100 includes a substrate 110, an anode layer 120 and a hole injection layer (HIL) 130 which may comprise a metal complex of formula (I) and a compound of formula (II). The HIL 130 is disposed on the anode layer 120. Onto the HIL 130, an emission layer (EML) 150, and a cathode layer 190 are disposed.

FIG. 2 is a schematic sectional view of an organic electronic device 100, according to an exemplary embodiment of the present invention. The organic electronic device 100 includes a substrate 110, an anode layer 120 and a hole injection layer (HIL) 130 which may comprise a metal complex of formula (I) and a compound of formula (II). The HIL 130 is disposed on the anode layer 120. Onto the HIL 130, a hole transport layer (HTL) 140, an emission layer (EML) 150, an electron transport layer (ETL) 160, an electron injection layer (EIL) 180 and a cathode layer 190 are disposed. Instead of a single electron transport layer 160, optionally an electron transport layer stack (ETL) can be used.

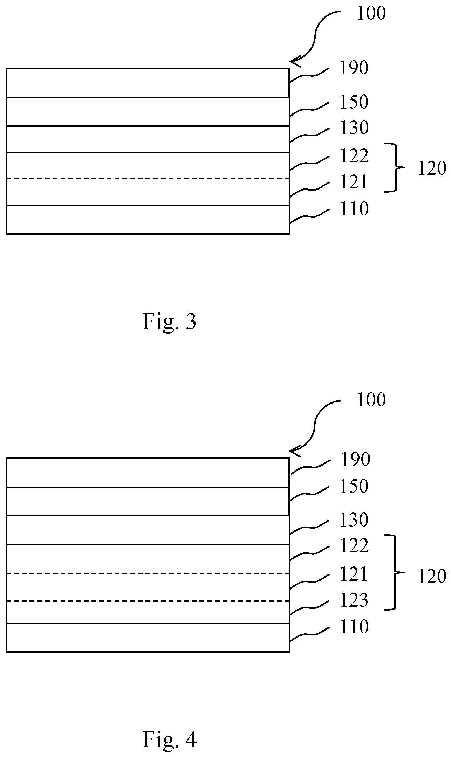

FIG. 3 is a schematic sectional view of an organic electronic device (100), according to an exemplary embodiment of the present invention. The organic electronic device (100) includes a substrate (110), an anode layer (120) that comprises a first anode sub-layer (121) and a second anode sub-layer (122) and a hole injection layer (HIL) (130). The HIL (130) is disposed on the anode layer (120). Onto the HIL (130), a first emission layer (EML) (150), and a cathode layer (190) are disposed.

FIG. 4 is a schematic sectional view of an organic electronic device (100), according to an exemplary embodiment of the present invention. The organic electronic device (100) includes a substrate (110), an anode layer (120) that comprises a first anode sub-layer (121), a second anode sub-layer (122) and a third anode sub-layer (123), and a hole injection layer (HIL) (130). The HIL (130) is disposed on the anode layer (120) comprising a first anode sub-layer (121), a second anode sub-layer (122) and a third anode sub-layer (123). Onto the HIL (130), a first emission layer (EML) (150), and a cathode layer (190) are disposed.

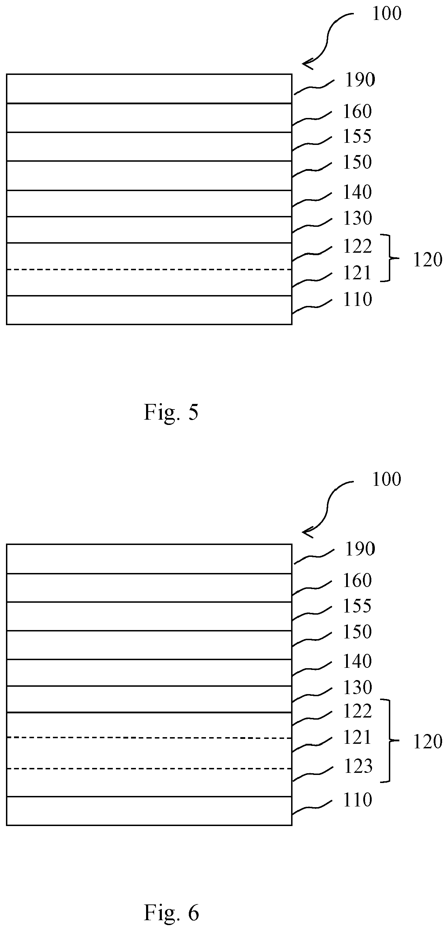

FIG. 5 is a schematic sectional view of an organic electronic device (100), according to an exemplary embodiment of the present invention. The organic electronic device (100) includes a substrate (110), an anode layer (120) that comprises a first anode sub-layer (121) and a second anode sub-layer (122), and a hole injection layer (HIL) (130). The HIL (130) is disposed on the anode layer (120). Onto the HIL (130), an hole transport layer (HTL) (140), a first emission layer (EML) (150), a hole blocking layer (BL) (155), an electron transport layer (ETL) (160), and a cathode layer (190) are disposed.

FIG. 6 is a schematic sectional view of an organic electronic device (100), according to an exemplary embodiment of the present invention. The organic electronic device (100) includes a substrate (110), an anode layer (120) that comprises a first anode sub-layer (121), a second anode sub-layer (122) and a third anode sub-layer (123), and a hole injection layer (HIL) (130). The HIL (130) is disposed on the anode layer (120). Onto the HIL (130), an hole transport layer (HTL) (140), a first emission layer (EML) (150), a hole blocking layer (HBL) (155), an electron transport layer (ETL) (160), and a cathode layer (190) are disposed.

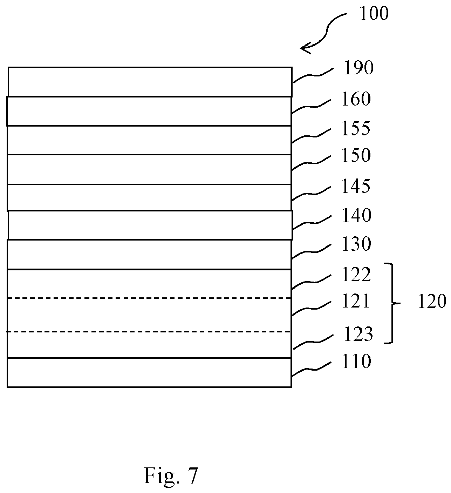

FIG. 7 is a schematic sectional view of an organic electronic device (100), according to an exemplary embodiment of the present invention. The organic electronic device (100) includes a substrate (110), an anode layer (120) that comprises a first anode sub-layer (121) and a second anode sub-layer (122) and a hole injection layer (HIL) (130). The HIL (130) is disposed on the anode layer (120). Onto the HIL (130), a hole transport layer (HTL) (140), an electron blocking layer (EBL) (145), a first emission layer (EML) (150), a hole blocking layer (HBL) (155), an electron transport layer (ETL) (160), and a cathode layer (190) are disposed.

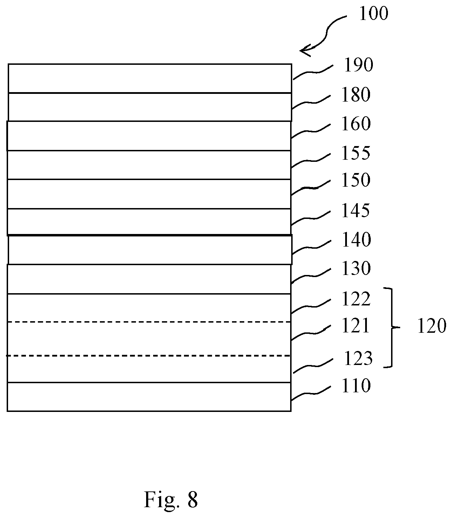

FIG. 8 is a schematic sectional view of an organic electronic device (100), according to an exemplary embodiment of the present invention. The organic electronic device (100) includes a substrate (110), an anode layer (120) that comprises a first anode sub-layer (121), a second anode sub-layer (122) and a third anode sub-layer (123), and a hole injection layer (HIL) (130). The HIL (130) is disposed on the anode layer (120). Onto the HIL (130), a hole transport layer (HTL) (140), an electron blocking layer (EBL) (145), a first emission layer (EML) (150), a hole blocking layer (HBL) (155), an electron transport layer (ETL) (160), an electron injection layer (EIL) (180) and a cathode layer (190) are disposed.

While not shown in Fig. 1 to Fig. 8, a capping and/or a sealing layer may further be formed on the cathode layer 190, in order to seal the organic electronic device 100. In addition, various other modifications may be applied thereto.

Hereinafter, the embodiments are illustrated in more detail with reference to examples. However, the present disclosure is not limited to the following examples.

### Detailed description

The invention is furthermore illustrated by the following examples which are illustrative only and non-binding.

### Metal complexes of formula (I)

Metal complexes of formula (I) may be prepared by known methods or as described below.

### Synthesis of 2-(3,5-bis(trifluoromethyl)benzoyl)-3-(3,5-bis(trifluoromethyl)phenyl)-3-oxopropanenitrile

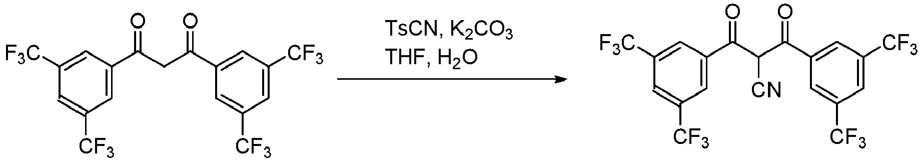

To a solution of 17.37 g (35 mmol) of 1,3-bis(3,5-bis(trifluoromethyl)phenyl)propane-1,3-dione and K₂CO₃ (7.26g, 52.5 mmol) in THF-water was added *p*-Tolylsulfonylcyanid (9.51g, 52.5 mmol) in one portion and the resulting mixture was stirred at RT for 3 h. The reaction mixture was cooled to 0°C, acidified with aq. 2M HCl, and extracted 2x500 ml of ethyl acetate. The combined organic phases were dried over MgSO4 and concentrated. Crude product was triturated in mixture of 100 ml hexane and 10 ml ethyl acetate for 1 h. Solid precipitate was filtered and washed with hexane. Filtrate was purified by chromatography on silica gel (DCM/Ethyl acetate/Hexane). Fractions with product were concentrated followed by acidic extraction (aq. 2M HCl/ethyl acetate). The combined organic phases were dried over MgSO4 and concentrated. Product was triturated in 20% Et₂O in hexane for 2 h, solid was filtered, washed with hexane, and dried. Yield 9.52 g (52%).

### Synthesis of bis(((Z)-1,3-bis(3,5-bis(trifluoromethyl)phenyl)-2-cyano-3-oxoprop-1-en-1-yl)oxy)copper (MC-1)

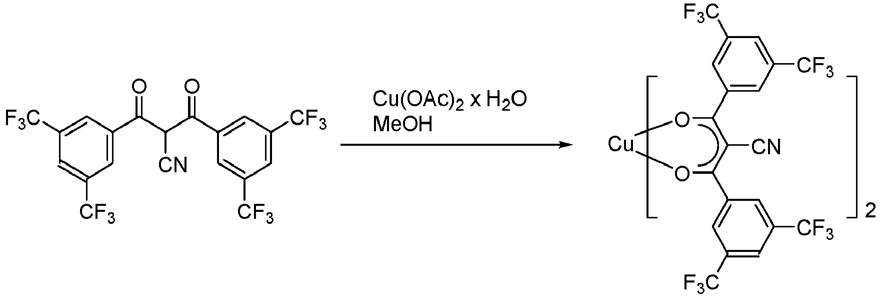

2.42g (4.64mmol) of 2-(3,5-bis(trifluoromethyl)benzoyl)-3-(3,5-bis(trifluoromethyl)phenyl)-3-oxopropanenitrile were dissolved in 40ml methanol and solution of 0.46g (2.32mmol) copper(II) acetate monohydrate in 30ml methanol and 20ml water was added. The mixture was stirred at room temperature overnight. The precipitate was filtered off, washed with water and dried in high vacuum. 2.29g (89%) product was obtained as a powder.

### Synthesis of 2-(3',5'-bis(trifluoromethyl)-[1,1'-biphenyl]-4-carbonyl)-4,4,5,5,5-pentafluoro-3-oxopentanenitrile

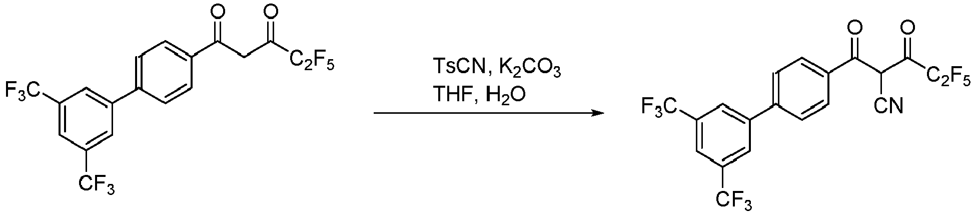

To a solution of 16.7 g (35 mmol) of 1-(3',5'-bis(trifluoromethyl)-[1,1'-biphenyl]-4-yl)-4,4,5,5,5-pentafluoropentane-1,3-dione and K₂CO₃ (7.26g, 52.5 mmol) in THF-water was added p-Tolylsulfonylcyanid (9.51g, 52.5 mmol) in one portion and the resulting mixture was stirred at RT for 20 h. THF was removed and 300 ml water and 300 ml DCM were added and stirred in ice/water bath for 30 min. White solid was filtered and washed with 2x300 ml water and 2x300 ml DCM and dried. Crude material was suspended in 100 ml DCM and 60 ml 1M HCl for 30 min, Layers were separated. Organic phase was washed with 30 ml of 1M HCl. Combined aq. phases were washed with 100 ml DCM. Combined organic phases were washed with 100 ml water, dried over MgSO₄ and concentrated at 40 °C. 100 ml hexane was added and stirred with 5 ml DCM in ice/water bath for 1 h. Solid was filtered, washed with cold hexane and dried. 14.27g (yield 81%).

### Synthesis of bis(((Z)-1-(3',5'-bis(trifluoromethyl)-[1,1'-biphenyl]-4-yl)-2-cyano-4,4,5,5,5-pentafluoro-3-oxopent-1-en-1-yl)oxy)copper (MC-2)

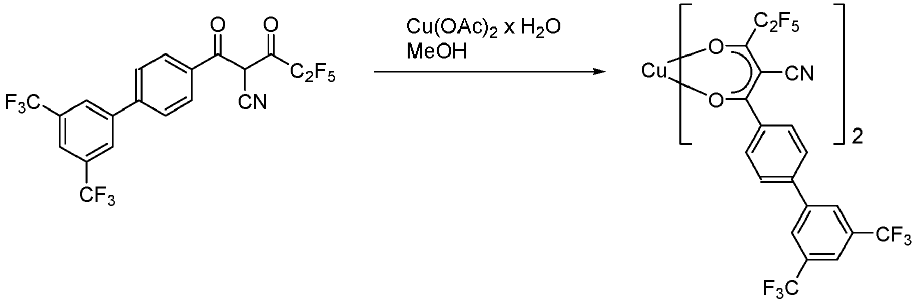

5.0g (9.94mmol) of 2-(3',5'-bis(trifluoromethyl)-[1,1'-biphenyl]-4-carbonyl)-4,4,5,5,5-pentafluoro-3-oxopentanenitrile were dissolved in 50ml methanol and 0.99g (4.97mmol) copper(II) acetate monohydrateand 20ml water were added. The mixture was stirred at room temperature overnight. The precipitate was filtered off, washed with water and dried in high vacuum. The crude product was crystallised from chloroform/ethyl acetate to obtain 3.60g (68%) product as a solid.

### Synthesis of N-methoxy-N-methyl-2-(trifluoromethyl)isonicotinamide

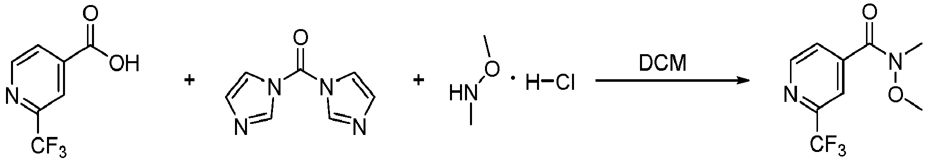

Flask was charged with 2-(trifluoromethyl)isonicotinic acid (20.1g, 100 mmol), dichloromethane (100 ml) and CDI (19.4g, 120 mmol) was added within 10 min. RM was stirred at r.t. for 1.5 h. Then, N,O-dimethylhydroxylamine hydrochloride (14.6g, 150mmol) was added and reaction mixture was stirred at r.t. for 17 h (overnight). Reaction was quenched with 1 M sol. of NaOH (50 mL) and extracted with dichloromethane (2x100 mL). Combined organic layers were washed with water, brine and solvent was evaporated in vacuo to give an oil (20.5 g, yield 87%).

### Synthesis of 1-(2-(trifluoromethyl)pyridin-4-yl)propan-1-one

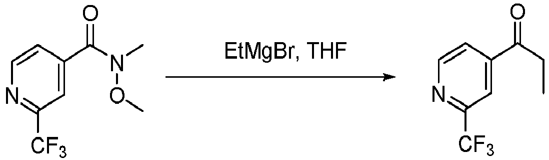

Flask was charged with N-methoxy-N-methyl-2-(trifluoromethyl)isonicotinamide (20.3g, 87 mmol), evacuated and filled with Ar. THF was added and RM was cooled to -79 °C. Then, EtMgBr (3M in THF, 130 mmol)) was added dropwise within 15 min. The reaction mixture was stirred at -79 °C for 1 h and then 0 °Cfor 2 h. Upon completion, the reaction mixture was poured into sol. of NH₄Cl and extracted with Et₂O. Obtained red oil was purified by column chromatography (hexane-ethyl acetate) to give product as a liquid (13.2, yield 74%).

### Synthesis of 2-methyl-1,3-bis(2-(trifluoromethyl)pyridin-4-yl)propane-1,3-dione

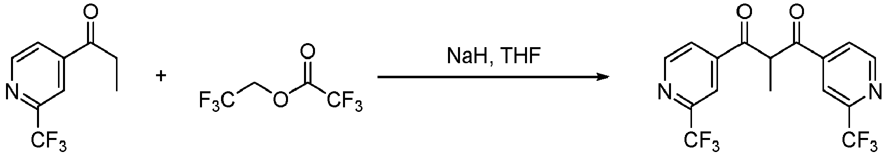

Flask was charged with 1-(2-(trifluoromethyl)pyridin-4-yl)propan-1-one (10.2g, 50 mmol), evacuated and filled with Ar. THF was added, reaction mixture was cooled to 0 °C and NaH (2.4g, 100 mmol) was added. Reaction mixture was stirred for 30 min. and 2,2,2-trifluoroethyl trifluoroacetate (5.9g, 30 mmol) was added dropwise within 20 min and mixture was stirred at 0 °C for 30 min. Upon completion reaction was quenched at 0 °C by diluted HCl and extracted with Et₂O, combined organic layers were washed with water, brine, dried over Na₂SO₄ and solvent was evaporated in vacuo. The residue was purified by column chromatography (Hexane, ethyl acetate). Obtained yellow solid was triturated with 20 mL of Et₂O, filtrated off and washed with cold Et₂O. Colourless product was obtained 4.42 g (47%).

### Synthesis of bis(((Z)-2-methyl-3-oxo-1,3-bis(2-(trifluoromethyl)pyridin-4-yl)prop-1-en-1-yl)oxy)copper (MC-3)

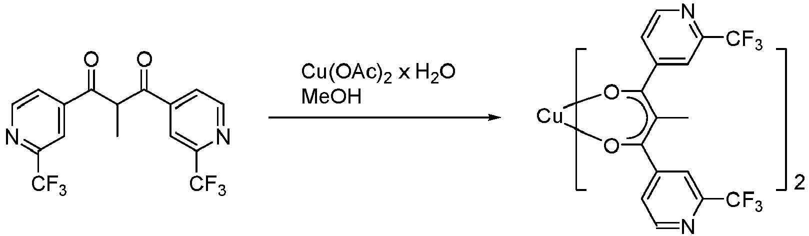

2.50g (6.64mmol) of 2-methyl-1,3-bis(2-(trifluoromethyl)pyridin-4-yl)propane-1,3-dione were dissolved in 25ml methanol and 0.66g (3.32mmol) copper(II) acetate monohydrate and 10ml water were added. The mixture was stirred at room temperature overnight. The precipitate was filtered off, washed with water and dried in high vacuum. The crude product was stirred in 200mL hot ethyl acetate, filtered off and dried in high vacuum to obtain 1.97g (73%) product as a solid.

### Synthesis of bis(((Z)-2-methyl-3-oxo-1,3-bis(2-(trifluoromethyl)pyridin-4-yl)prop-1-en-1-yl)oxy)copper (MC-4)

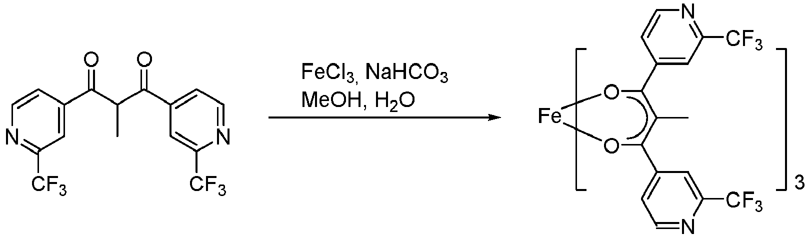

2.98g (7.70mmol) of 2-methyl-1,3-bis(2-(trifluoromethyl)pyridin-4-yl)propane-1,3-dione were dissolved in 60ml methanol and 0.65g (7.70mmol) sodium bicarbonate was added. 0.41g (2.57mmol) iron trichloride were dissolved in 2ml water and added dropwise to the reaction. The mixture was stirred at room temperature overnight. The precipitate was filtered off, washed with water and dried in high vacuum. 0.73g (24%) product were obtained as a solid.

Further compounds according to invention may be prepared by the methods described above or by methods known in the art.

**Table 1: Formulae of comparative compounds CC-1 and CC-2 and metal complex of Formula (I) MC-1 to MC-4**

| Name | Formula |
|---|---|
| CC-1 | 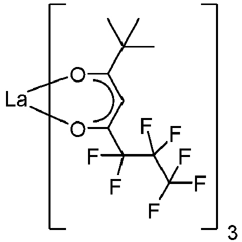 |
| CC-2 | 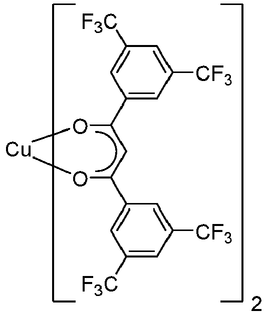 |
| MC-1 | 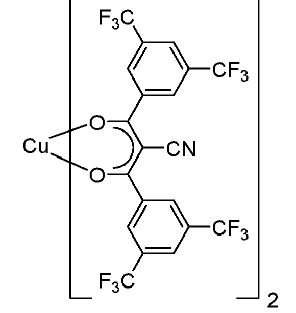 |
| MC-2 | 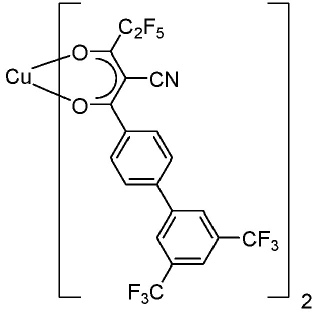 |
| MC-3 | 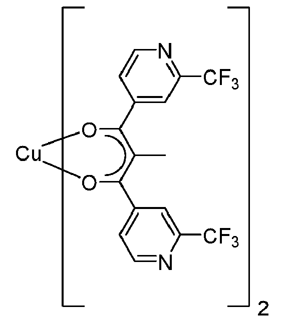 |
| MC-4 | 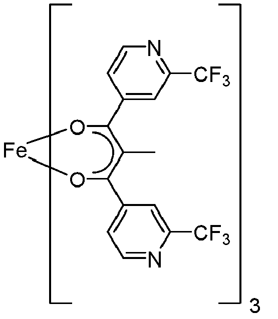 |

### Compounds of formula (II)

Compounds of formula (II) may be prepared by methods known in the art.

### HOMO and LUMO levels

The HOMO and LUMO levels are calculated with the program package TURBOMOLE V6.5 (TURBOMOLE GmbH, Litzenhardtstrasse 19, 76135 Karlsruhe, Germany). The optimized geometries and the HOMO and LUMO energy levels of the molecular structures are determined by applying the hybrid functional B3LYP with a 6-31G* basis set in the gas phase. If more than one conformation is viable, the conformation with the lowest total energy is selected.

### General procedure for fabrication of organic electronic devices comprising a hole injection layer comprising a metal complex and a compound of formula (II) wherein the hole injection layer is deposited in vacuum

For inventive examples 1-1 to 1-7 and comparative examples 1-1 to 1-4 in Table 2 a glass substrate with an anode layer comprising a first anode sub-layer of 120 nm Ag, a second anode sub-layer of 8 nm ITO and a third anode sub-layer of 10 nm ITO was cut to a size of 50 mm x 50 mm x 0.7 mm, ultrasonically washed with water for 60 minutes and then with isopropanol for 20 minutes. The liquid film was removed in a nitrogen stream, followed by plasma treatment to prepare the anode layer. The plasma treatment was performed in an atmosphere comprising 97.6 vol.-% nitrogen and 2.4 vol.-% oxygen.

Then, the compound of formula (II) and the metal complex were co-deposited in vacuum on the anode layer, to form a hole injection layer (HIL) having a thickness of 10 nm. The composition of the hole injection layer can be seen in Table 2. The formulae of the metal complexes can be seen in Table 1.

Then, the compound of formula (II) was vacuum deposited on the HIL, to form a HTL having a thickness of 123 nm. The compound of formula (II) in the HTL is selected the same as the compound of formula (II) in the HIL. The compound of formula (II) can be seen in Table 2.

Then N-(4-(dibenzo[b,d]furan-4-yl)phenyl)-N-(4-(9-phenyl-9H-fluoren-9-yl)phenyl)-[1,1'-biphenyl]-4-amine (CAS 1824678-59-2) was vacuum deposited on the HTL, to form an electron blocking layer (EBL) having a thickness of 5 nm.

Then 97 vol.-% H09 as EML host and 3 vol.-% BD200 (Sun Fine Chemicals, Korea) as fluorescent blue emitter dopant were deposited on the EBL, to form a blue-emitting first emission layer (EML) with a thickness of 20 nm.

Then a hole blocking layer was formed with a thickness of 5 nm by depositing 2-(3'-(9,9-dimethyl-9H-fluoren-2-yl)-[1,1'-biphenyl]-3-yl)-4,6-diphenyl-1,3,5-triazine on the emission layer EML

Then the electron transporting layer having a thickness of 31 nm was formed on the hole blocking layer by depositing 50 wt.-% 4'-(4-(4-(4,6-diphenyl-1,3,5-triazin-2-yl)phenyl)naphthalen-1-yl)-[1,1'-biphenyl]-4-carbonitrile and 50 wt.-% of LiQ.

Then Ag:Mg (90:10 vol.-%) was evaporated at a rate of 0.01 to 1 Å/s at 10⁻⁷ mbar to form a cathode layer with a thickness of 13 nm on the electron transporting layer.

Then, K1 was deposited on the cathode layer to form a capping layer with a thickness of 75 nm.

The OLED stack is protected from ambient conditions by encapsulation of the device with a glass slide. Thereby, a cavity is formed, which includes a getter material for further protection.

### General method for preparation of the ink formulation

To prepare the ink formulation, under inert atmosphere the compounds were weighed into vials. Then, the solvent was added. The mixture was stirred at 60 °C for 10 min. After cooling to room temperature, an aliquot of benzonitrile solutions was added to the anisole solution to obtain a solution with a ratio of 5:1 of anisole to benzonitrile solution. The resulting solution was stirred again for at least 10 min at room temperature. The resulting ink formulation had a solid content of 3 wt.-%.

### Ink formulation for inventive example 2-1

The ink formulation for example 2-1 has the following composition: 10 wt.-%_MC-2 : K1 in anisole : benzonitrile (5:1).

To prepare the ink, solutions of 15 mg MC-2 in 0.8 ml benzonitrile and 139 mg K1 in 4.2 ml anisole were prepared as described above. 0.8 ml benzonitrile solution was added to the anisole solution and stirred as described above.

### Ink formulation for inventive example 2-2

The ink formulation for example 2-2 has the following composition: 10 wt.-%_MC-3 : K1 in anisole : benzonitrile (5:1).

To prepare the ink, solutions of 15 mg MC-3 in 0.8 ml benzonitrile and 139 mg K1 in 4.2 ml anisole were prepared as described above. 0.8 ml benzonitrile solution was added to the anisole solution and stirred as described above.

### General procedure for fabrication of electronic devices comprising a hole injection layer comprising a metal complex and a matrix compound wherein the hole injection layer is deposited from solution

For bottom emission OLEDs, see Examples 2-1 and 2-2 in Table 3, a 15Ω /cm² glass substrate with 90 nm ITO (available from Corning Co.) with the dimensions 150 mm x 150 mm x 0.7 mm was ultrasonically washed with isopropyl alcohol for 5 minutes and then with pure water for 5 minutes and dried at elevated temperature.

To form the hole injection layer having a thickness of 45 nm on the anode layer, the substrate is placed on a spin-coater with ITO side facing upwards and fixed with vacuum. 5 ml of ink formulation is applied with a syringe with filter (PTFE - 0,45µm) on the substrate. Spin-coating parameter are 850 rpm (3sec ramp-up from zero to maximum speed) for 30sec. The resulting film is dried at 60°C for 1 minute on a hotplate. Next step is the cleaning of the substrate around the active area (to ensure a good encapsulation process after evaporation). An additional bake-out at 100°C for 10 minutes on a hotplate is done. The composition of the hole injection layer can be seen in Table 3. The formulae of the metal complexes can be seen in Table 1.

Then, the substrate is transferred to a vacuum chamber.

Then, Biphenyl-4-yl(9,9-diphenyl-9H-fluoren-2-yl)-[4-(9-phenyl-9H-carbazol-3-yl) phenyl]-amine was vacuum deposited on the HIL, to form a first HTL having a thickness of 89 nm.

Then N,N-di([1,1'-biphenyl]-4-yl)-3'-(9H-carbazol-9-yl)-[1,1'-biphenyl]-4-amine (CAS 1464822-27-2) was vacuum deposited on the HTL, to form an electron blocking layer (EBL) having a thickness of 5 nm.

Then 97 vol.-% H09 (Sun Fine Chemicals, Korea) as EML host and 3 vol.-% BD200 (Sun Fine Chemicals, Korea) as fluorescent blue dopant were deposited on the EBL, to form a first blue-emitting emission layer (EML) with a thickness of 20 nm.

Then a hole blocking layer is formed with a thickness of 5 nm by depositing 2-(3'-(9,9-dimethyl-9H-fluoren-2-yl)-[1,1'-biphenyl]-3-yl)-4,6-diphenyl-1,3,5-triazine on the emission layer.

Then, the electron transporting layer having a thickness of 31 nm is formed on the hole blocking layer by depositing 4'-(4-(4-(4,6-diphenyl-1,3,5-triazin-2-yl)phenyl)naphthalen-1-yl)-[1,1'-biphenyl]-4-carbonitrile and LiQ in a ratio of 50:50 vol.-%.

Then, an electron injection layer is formed having a thickness of 2 nm by depositing Yb onto the electron transport layer.

Then, Al is evaporated at a rate of 0.01 to 1 A/s at 10-7 mbar to form a cathode layer with a thickness of 100 nm onto the electron injection layer.

The OLED stack is protected from ambient conditions by encapsulation of the device with a glass slide. Thereby, a cavity is formed, which includes a getter material for further protection.

To assess the performance of the inventive examples compared to the prior art, the current efficiency is measured at 20°C. The current-voltage characteristic is determined using a Keithley 2635 source measure unit, by sourcing a voltage in V and measuring the current in mA flowing through the device under test. The voltage applied to the device is varied in steps of 0.1V in the range between 0V and 10V. Likewise, the luminance-voltage characteristics and CIE coordinates are determined by measuring the luminance in cd/m² using an Instrument Systems CAS-140CT array spectrometer (calibrated by Deutsche Akkreditierungsstelle (DAkkS)) for each of the voltage values. The cd/A efficiency at 10 mA/cm² is determined by interpolating the luminance-voltage and current-voltage characteristics, respectively.

In bottom emission devices, the emission is predominately Lambertian and quantified in percent external quantum efficiency (EQE). The light is emitted through the anode layer. To determine the efficiency EQE in % the light output of the device is measured using a calibrated photodiode at 10 mA/cm2.

In top emission devices, the emission is forward directed through the cathode layer, non-Lambertian and also highly dependent on the mirco-cavity. Therefore, the efficiency EQE will be higher compared to bottom emission devices. To determine the efficiency EQE in % the light output of the device is measured using a calibrated photodiode at 10 mA/cm².

Lifetime LT of the device is measured at ambient conditions (20°C) and 30 mA/cm², using a Keithley 2400 sourcemeter, and recorded in hours.

The brightness of the device is measured using a calibrated photo diode. The lifetime LT is defined as the time till the brightness of the device is reduced to 97 % of its initial value.

To determine the voltage stability over time U(100h)-(1h), a current density of at 30 mA/cm² was applied to the device. The operating voltage was measured after 1 hour and after 100 hours, followed by calculation of the voltage stability for the time period of 1 hour to 100 hours. A low value for U(100h)-(1h) denotes a low increase in operating voltage over time and thereby improved voltage stability.

### Technical Effect of the invention

In Table 2 are shown data for top emission organic electronic devices fabricated by codeposition from vacuum of metal complex and compound of formula (II).

In comparative examples 1-1 to 1-4, two metal complexes known in the art are tested at two different doping concentrations.

As can be seen in Table 2, in comparative examples 1-1 to 1-4 the operating voltage is between 3.67 and 3.78 V, the external quantum efficiency EQE is between 12.9 and 13.91 % and the voltage stability over time is between 0.85 and 1.28 V.

In inventive example 1-1, the semiconductor layer comprises metal complex of formula (I) MC-1. MC-1 comprises a group R² selected from CN. As can be seen in Table 2, the EQE is improved to 14.32 % and operating voltage stability over time is improved to 0.46 V.

In inventive examples 1-2, the semiconductor layer comprises 15 vol.-% MC-1. As can be seen in Table 2, EQE and operating voltage stability over time remain improved over comparative examples 1-1 to 1-4.

In inventive examples 1-3 to 1-7, the semiconductor layer comprises metal complex of formula (1) at a range of doping concentrations and compounds of formula (II) with a range of HOMO levels. As can be seen in Table 2, EQE and operating voltage stability over time are improved over comparative examples 1-1 to 1-4.

In Table 3 are shown data for bottom emission organic electronic devices fabricated by codeposition from solution of metal complex of formula (I) and compound of formula (II).

As can be seen in Table 3, good performance of organic electronic devices is obtained.

A high efficiency and/or improved operating voltage stability over time are important for the performance and long-term stability of organic electronic devices.

**Table 2: Performance of an organic electronic device comprising a metal complex prepared via vacuum thermal evaporation**

| | Metal complex | Percentage metal complex in semiconductor layer [vol.-%] | Compound of formula (II) | HOMO level of compound of formula (II) [eV] | Percentage compound of formula (II) in semiconductor layer [vol.-%] | U at 10 mA/cm² [V] | EQE at 10 mA/cm² [%] | U(100 h)-U(1 h) (30mA/cm²) [V] |
|---|---|---|---|---|---|---|---|---|
| Comparative example 1-1 | CC-1 | 5 | K1 | -4.68 | 95 | 3.67 | 12.99 | 0.85 |
| Comparative example 1-2 | CC-2 | 6 | K1 | -4.68 | 94 | 3.8 | 13.91 | 1.24 |
| Comparative example 1-3 | CC-1 | 9 | K1 | -4.68 | 91 | 3.65 | 12.90 | 0.89 |
| Comparative example 1-4 | CC-2 | 10 | K1 | -4.68 | 90 | 3.78 | 13.81 | 1.28 |
| Inventive example 1-1 | MC-1 | 10 | K1 | -4.68 | 90 | 3.75 | 14.32 | 0.46 |
| Inventive example 1-2 | MC-1 | 15 | K1 | -4.68 | 85 | 3.73 | 14.36 | 0.47 |
| Inventive example 1-3 | MC-1 | 18 | K16 | -4.73 | 82 | 3.81 | 15.42 | 0.07 |
| Inventive example 1-4 | MC-1 | 22 | K16 | -4.73 | 78 | 3.8 | 15.44 | 0.06 |
| Inventive example 1-5 | MC-1 | 15 | K2 | -4.85 | 85 | 3.75 | 14.73 | 0.06 |
| Inventive example 1-6 | MC-1 | 21 | K2 | -4.85 | 79 | 3.74 | 14.72 | 0.03 |
| Inventive example 1-7 | MC-1 | 25 | K2 | -4.85 | 75 | 3.73 | 14.71 | 0.02 |

**Table 3: Performance of an organic electronic device comprising a metal complex prepared via deposition from solution**

| | Metal complex | Percentage metal complex in semiconductor layer [vol.-%] | Compound of formula (II) | Percentage compound of formula (II) in semiconductor layer [vol.-%] | U at 10 mA/cm² [V] | EQE at 10 mA/cm² [%] |
|---|---|---|---|---|---|---|
| Inventive example 2-1 | MC-2 | 10 | K1 | 90 | 3.83 | 13.06 |
| Inventive example 2-2 | MC-3 | 10 | K1 | 90 | 3.85 | 13.41 |

The particular combinations of elements and features in the above detailed embodiments are exemplary only; the interchanging and substitution of these teachings with other teachings in this and the patents/applications incorporated by reference are also expressly contemplated. As those skilled in the art will recognize, variations, modifications, and other implementations of what is described herein can occur to those of ordinary skill in the art without departing from the spirit and the scope of the invention as claimed. Accordingly, the foregoing description is by way of example only and is not intended as limiting. In the claims, the word "comprising" does not exclude other elements or steps, and the indefinite article "a" or "an" does not exclude a plurality. The mere fact that certain measures are recited in mutually different dependent claims does not indicate that a combination of these measured cannot be used to advantage. The invention's scope is defined in the following claims and the equivalents thereto. Furthermore, reference signs used in the description and claims do not limit the scope of the invention as claimed.

## Claims

1. An organic electronic device comprising a substrate, an anode layer, a cathode layer, at least one first emission layer, and a hole injection layer, wherein the hole injection layer comprises a metal complex of formula (I): 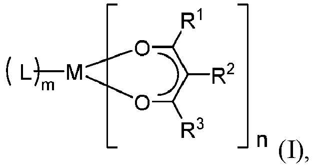 wherein
M is a metal;
L is a charge-neutral ligand, which coordinates to the metal M;
n is an integer selected from 1 to 4, which corresponds to the oxidation number of M;
m is an integer selected from 0 to 2;
R¹ and R³ are independently selected from H, D, substituted or unsubstituted C₁ to C₁₂ alkyl, substituted or unsubstituted C₁ to C₁₂ alkoxy, substituted or unsubstituted C₆ to C₂₄ aryl, and substituted or unsubstituted C₂ to C₂₄ heteroaryl group, wherein at least one substituent is selected from halogen, F, Cl, CN, substituted or unsubstituted C₁ to C₁₂ alkyl, partially or fully fluorinated C₁ to C₁₂ alkyl, substituted or unsubstituted C₁ to C₁₂ alkoxy, partially or fully fluorinated C₁ to C₁₂ alkoxy, substituted or unsubstituted C₆ to C₁₈ aryl, and substituted or unsubstituted C₂ to C₁₈ heteroaryl, wherein the substituents of the substituted or unsubstituted C₁ to C₁₂ alkyl, substituted or unsubstituted C₁ to C₁₂ alkoxy, substituted or unsubstituted C₆ to C₁₈ aryl, and substituted or unsubstituted C₂ to C₁₈ heteroaryl are selected from halogen, F, Cl, CN, C₁ to C₆ alkyl, CF₃, OCH₃, OCF₃;
R² is selected from CN, C₁ to C₄ alkyl, partially or perfluorinated C₁ to C₄ alkyl, or F;
wherein at least one R¹ and/or R³ is selected from a substituted C₆ to C₂₄ aryl or substituted C₂ to C₂₄ heteroaryl group,
wherein at least one substituent of the substituted C₆ to C₂₄ aryl or substituted C₂ to C₂₄ heteroaryl group is selected from CN or partially or fully fluorinated C₁ to C₁₂ alkyl;
and a compound of formula (II) 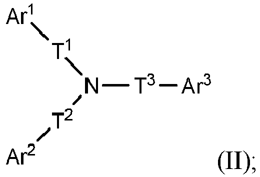
T¹, T², T³ are independently selected from a single bond, phenylene, biphenylene, terphenylene or naphthenylene, preferably a single bond or phenylene;
Ar¹, Ar², Ar³ are independently selected from substituted or unsubstituted C₆ to C₂₀ aryl, or substituted or unsubstituted C₃ to C₂₀ heteroarylene, substituted or unsubstituted biphenylene, substituted or unsubstituted fluorene, substituted 9-fluorene, substituted 9,9-fluorene, substituted or unsubstituted naphthalene, substituted or unsubstituted anthracene, substituted or unsubstituted phenanthrene, substituted or unsubstituted pyrene, substituted or unsubstituted perylene, substituted or unsubstituted triphenylene, substituted or unsubstituted tetracene, substituted or unsubstituted tetraphene, substituted or unsubstituted dibenzofurane, substituted or unsubstituted dibenzothiophene, substituted or unsubstituted xanthene, substituted or unsubstituted carbazole, substituted 9-phenylcarbazole, substituted or unsubstituted azepine, substituted or unsubstituted dibenzo[b,f]azepine, substituted or unsubstituted 9,9'-spirobi[fluorene], substituted or unsubstituted spiro[fluorene-9,9'-xanthene], or a substituted or unsubstituted aromatic fused ring system comprising at least three substituted or unsubstituted aromatic rings selected from the group comprising substituted or unsubstituted non-hetero, substituted or unsubstituted hetero 5-member rings, substituted or unsubstituted 6-member rings and/or substituted or unsubstituted 7-member rings, substituted or unsubstituted fluorene, or a fused ring system comprising 2 to 6 substituted or unsubstituted 5- to 7-member rings and the rings are selected from the group comprising (i) unsaturated 5- to 7-member ring of a heterocycle, (ii) 5- to 6-member of
an aromatic heterocycle, (iii) unsaturated 5- to 7-member ring of a non-heterocycle, (iv) 6-member ring of an aromatic non-heterocycle; wherein
the substituents of Ar¹, Ar², Ar³ are selected the same or different from the group comprising H, D, F, CN, Si(R²)₃, substituted or unsubstituted straight-chain alkyl having 1 to 20 carbon atoms, substituted or unsubstituted branched alkyl having 1 to 20 carbon atoms, substituted or unsubstituted cyclic alkyl having 3 to 20 carbon atoms, substituted or unsubstituted alkenyl or alkynyl groups having 2 to 20 carbon atoms, substituted or unsubstituted aromatic ring systems having 6 to 40 aromatic ring atoms, and substituted or unsubstituted heteroaromatic ring systems having 5 to 40 aromatic ring atoms, unsubstituted C₆ to C₁₈ aryl, unsubstituted C₃ to C₁₈ heteroaryl, a fused ring system comprising 2 to 6 unsubstituted 5- to 7-member rings and the rings are selected from the group comprising unsaturated 5- to 7-member ring of a heterocycle, 5- to 6-member of an aromatic heterocycle, unsaturated 5- to 7-member ring of a non-heterocycle, and 6-member ring of an aromatic non-heterocycle,
wherein R² may be selected from H, D, straight-chain alkyl having 1 to 6 carbon atoms, branched alkyl having 1 to 6 carbon atoms, cyclic alkyl having 3 to 6 carbon atoms, alkenyl or alkynyl groups having 2 to 6 carbon atoms, C₆ to C₁₈ aryl or C₃ to C₁₈ heteroaryl;
wherein the hole injection layer is arranged between the anode layer and the at least one first emission layer.

2. The organic electronic device according to claim 1, wherein M is selected from Li(I), Na(I), K(I), Rb(I), Cs(I), Cu(II), Zn(II), Pd(II), Al(III), Sc(III), Mn(III), In(III), Y(III), Eu(III), Fe(III), Zr(IV), Hf(IV) or Ce(IV).

3. The compound according to claim 1 or 2, wherein L is selected from the group comprising H₂O, C₂ to C₄₀ mono- or multi-dentate ethers and C₂ to C₄₀ thioethers, C₂ to C₄₀ amines, C₂ to C₄₀ phosphine, C₂ to C₂₀ alkyl nitrile or C₂ to C₄₀ aryl nitrile, or a compound according to Formula (II); 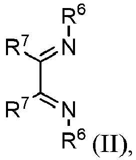 wherein R⁶ and R⁷ are independently selected from C₁ to C₂₀ alkyl, C₁ to C₂₀ heteroalkyl, C₆ to
C₂₀ aryl, heteroaryl with 5 to 20 ring-forming atoms, halogenated or perhalogenated C₁ to C₂₀ alkyl, halogenated or perhalogenated C₁ to C₂₀ heteroalkyl, halogenated or perhalogenated C₆ to C₂₀ aryl, halogenated or perhalogenated heteroaryl with 5 to 20 ring-forming atoms, or at least one R⁶ and R⁷ are bridged and form a 5 to 20 member ring, or the two R⁶ and/or the two R⁷ are bridged and form a 5 to 40 member ring or form a 5 to 40 member ring comprising an unsubstituted or C₁ to C₁₂ substituted phenanthroline.

4. The compound according to any of claims 1 to 3, wherein n is an integer selected from 1, 2 and 3, which corresponds to the oxidation number of M.

5. The organic electronic device according to any of the preceding claims 1 to 4, wherein R² is selected from CN, CH₃, CF₃, C₂F₅, C₃F₇ or F.

6. The organic electronic device according to any of the preceding claims 1 to 5, wherein the metal complex of formula (I) comprises at least one CF₃ group.

7. The organic electronic device according to any of the preceding claims 1 to 6, wherein the R¹ and/or R³ each are substituted by a maximum number of four substituents, preferably three more, preferably one or two.

8. The organic electronic device according to any of the preceding claims 1 to 7, wherein at least one R¹ and/or R³ is selected from a substituted C₆ to C₂₄ aryl or substituted C₂ to C₂₄ heteroaryl group,
wherein at least one substituent of the substituted C₆ to C₂₄ aryl or substituted C₂ to C₂₄ heteroaryl group is selected from CN or partially or fully fluorinated C₁ to C₁₂ alkyl.

9. The organic electronic device according to any of the preceding claims 1 to 8, wherein at least one substituted or unsubstituted C₆ to C₂₄ aryl or substituted or unsubstituted C₂ to C₂₄ heteroaryl of R¹ and/or R³ is selected from the following formulae D1 to D71: 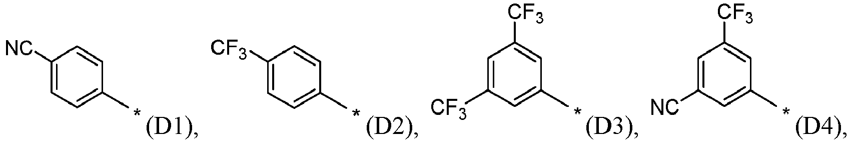 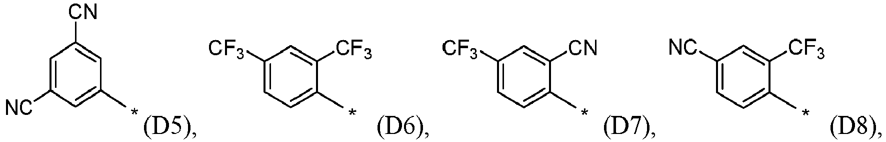 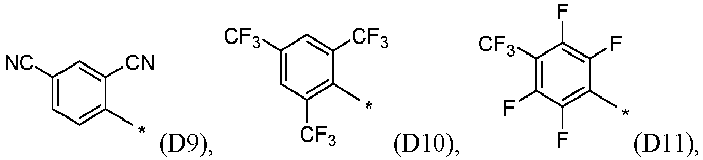 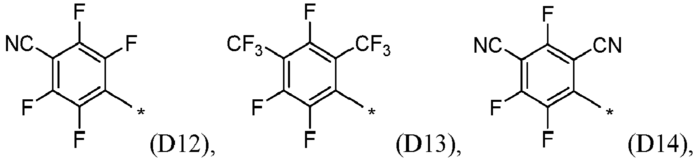 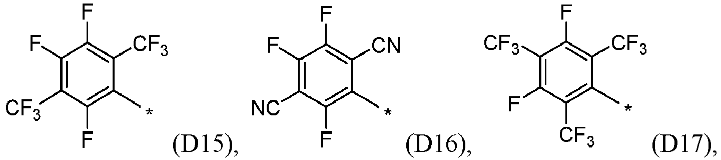 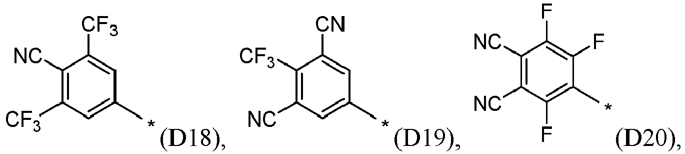 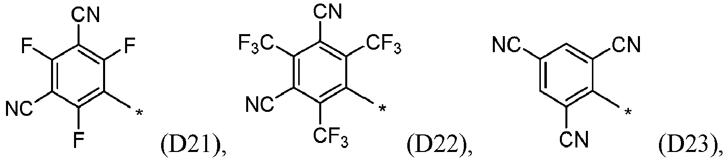 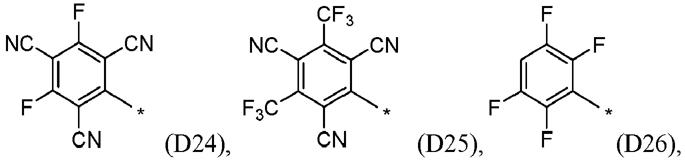 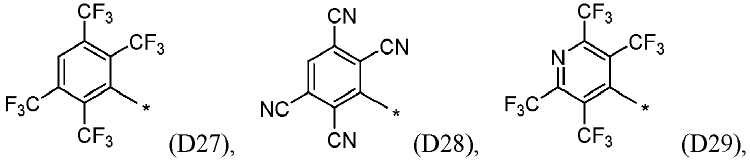 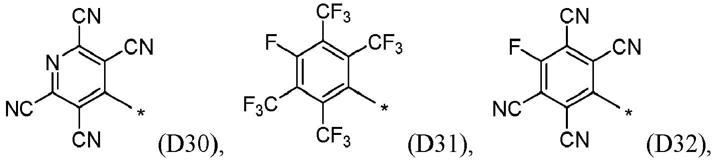 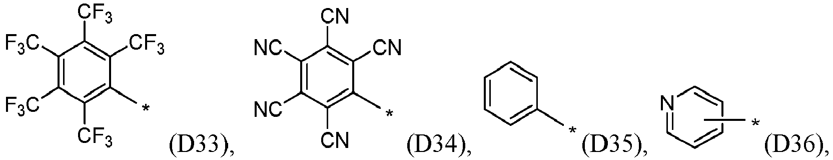 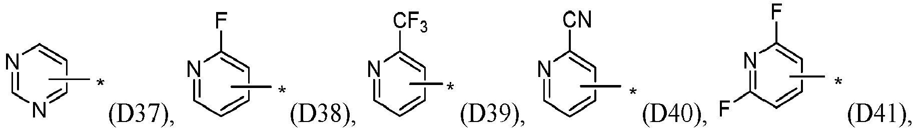 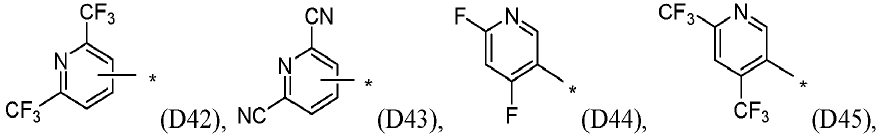 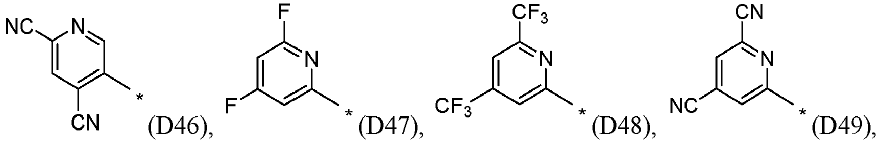 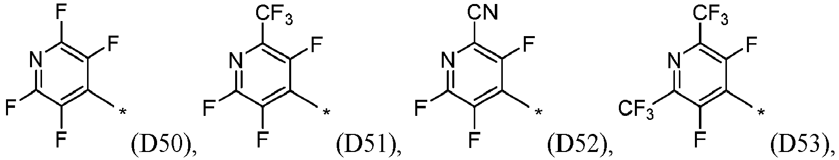 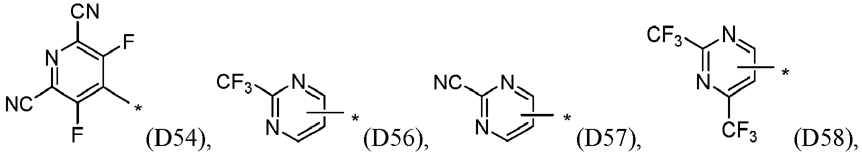 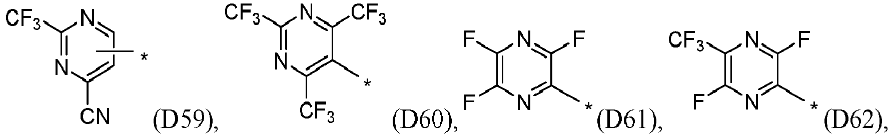 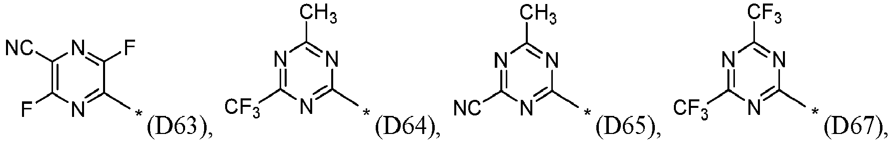 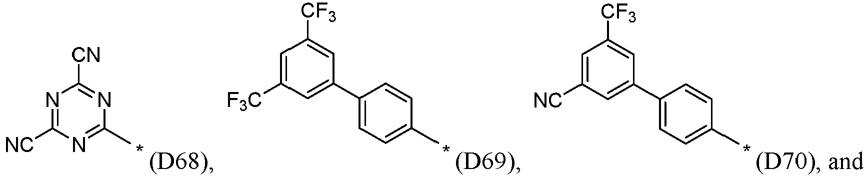 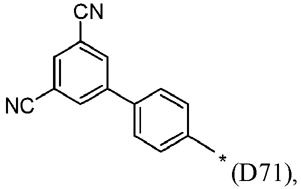 wherein the "*" denotes the binding position.

10. The organic electronic device according to any of the preceding claims 1 to 9, wherein the metal complex of formula (I) preferably is selected from one of the following formulae:

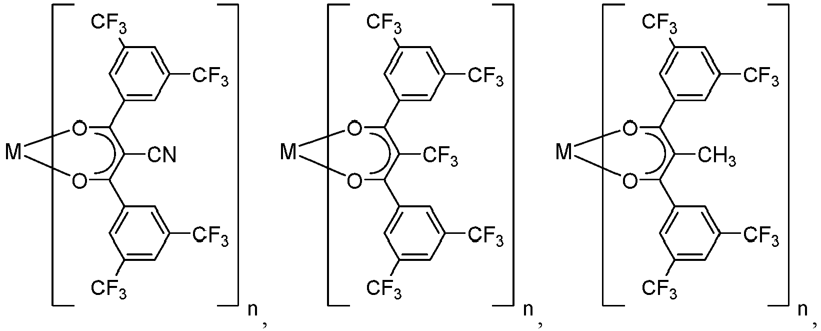

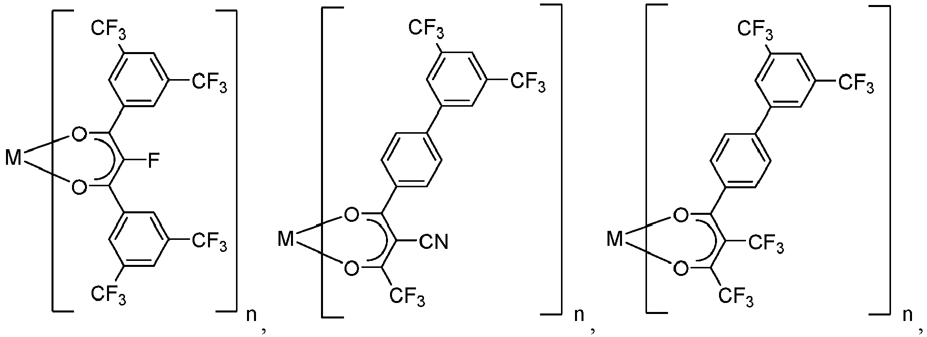

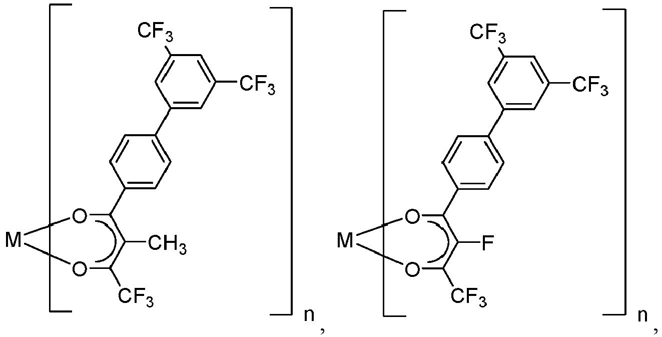

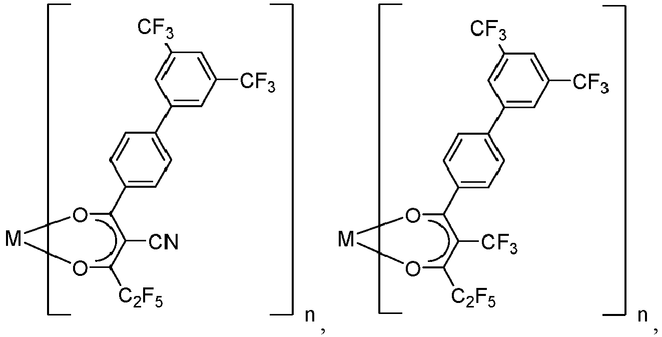

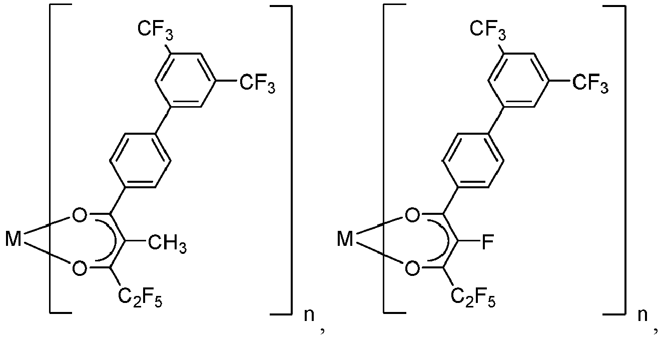

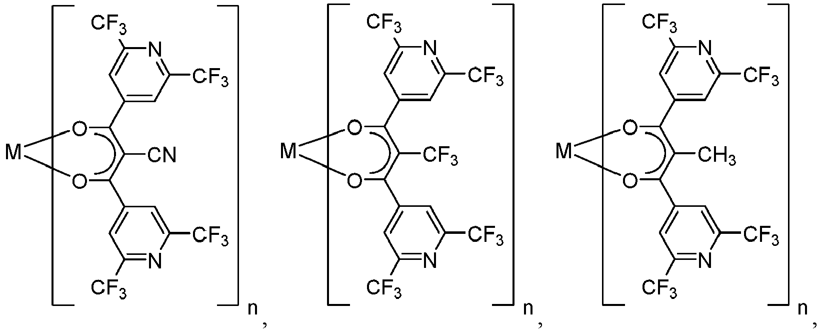

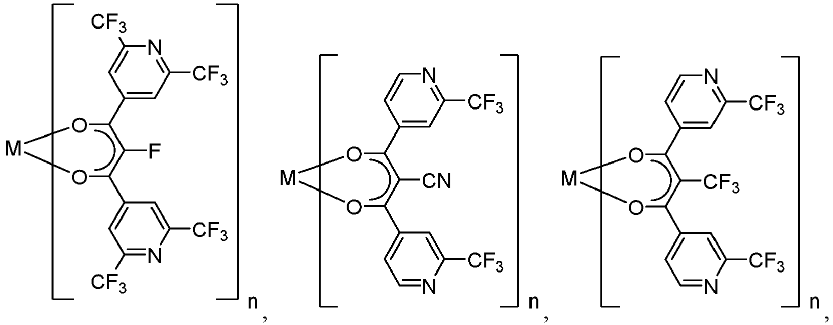

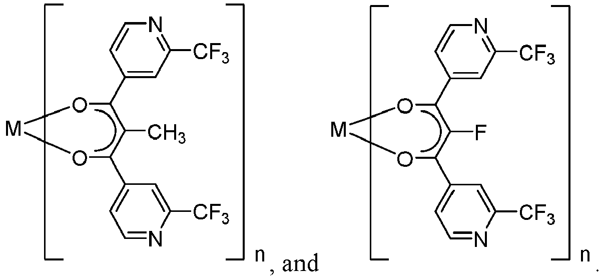

11. The organic electronic device according to any of the preceding claims 1 to 10, wherein the compound of formula (II) has a HOMO level smaller than the HOMO level of N2,N2,N2',N2',N7,N7,N7',N7'-octakis(4-methoxyphenyl)-9,9'-spirobi[fluorene]-2,2',7,7'-tetraamine, when determined by the same method.

12. The organic electronic device according to any of the preceding claims 1 to 11, wherein the compound of formula (II) is selected from one of the following formulae K1 to K16:

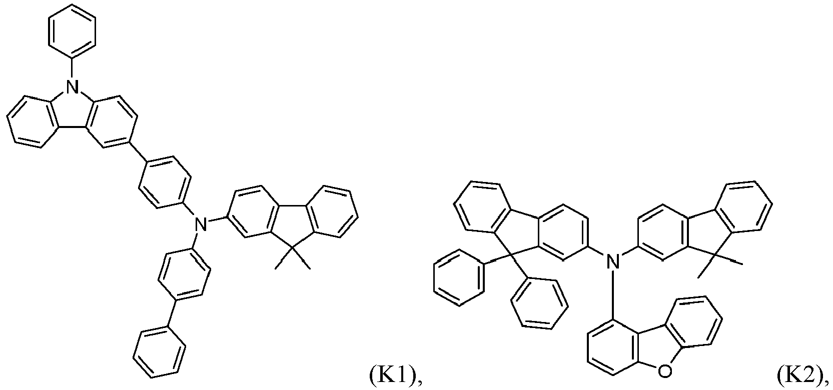

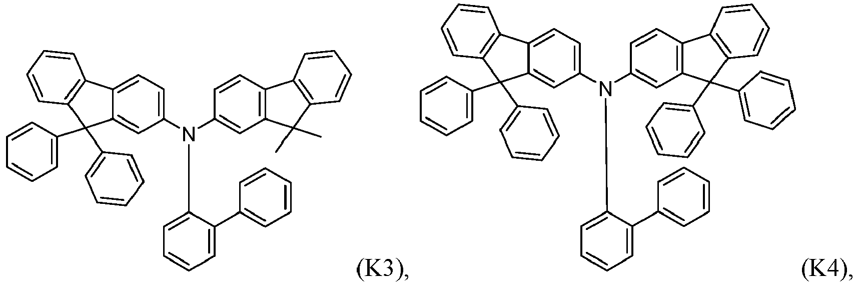

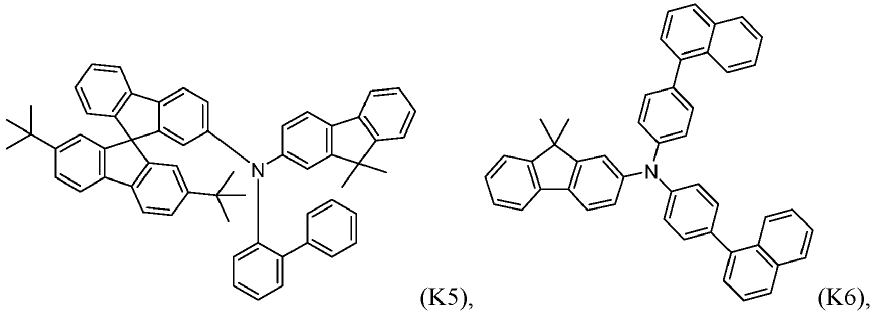

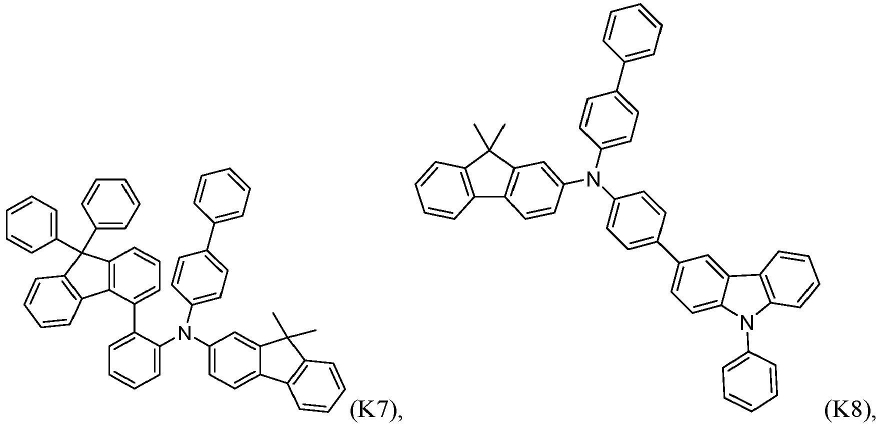

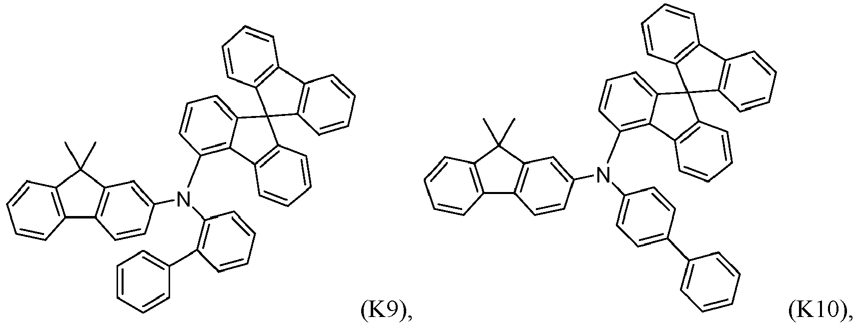

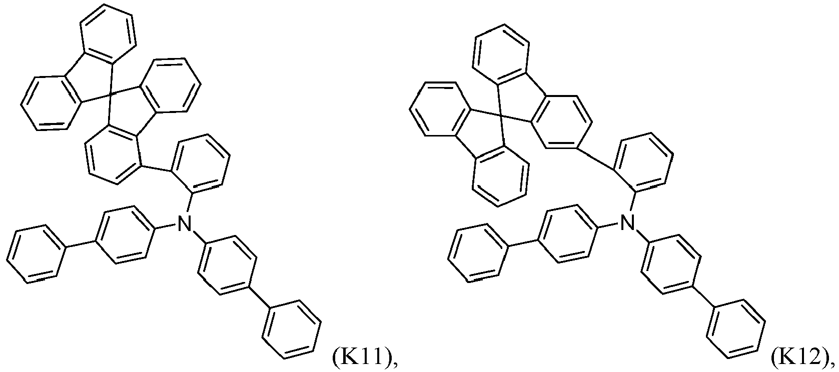

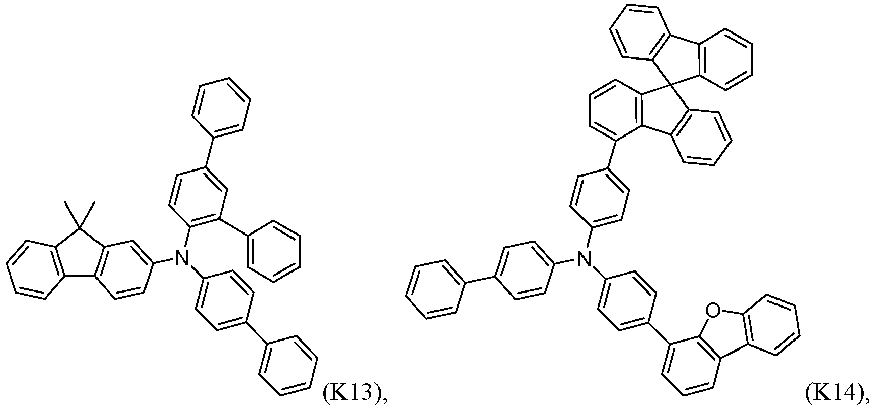

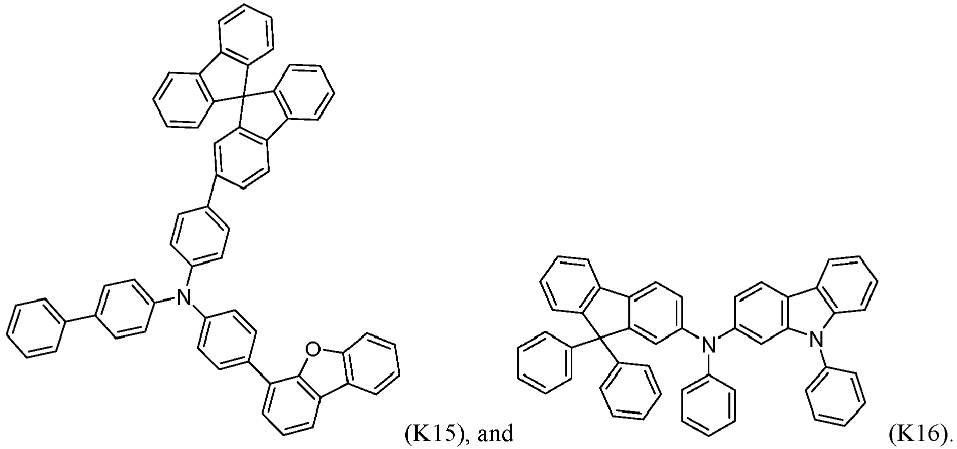

13. The organic electronic device according to any of preceding claims 1 to 12, wherein the organic electronic device further comprises a hole transport layer, wherein the hole transport layer is arranged between the hole injection layer and the at least one emission layer.

14. The organic electronic device according to claim 13, wherein the hole transport layer comprises a matrix compound.

15. The organic electronic device according to any of the preceding claims 1 to 14, wherein the organic electronic device is a light emitting device or a display device.
